Europäisches Patentamt

European Patent Office

Office européen des brevets

(19)

(11) EP 1 489 749 A2

(12) **EUROPEAN PATENT APPLICATION**

| | |
|---|---|
| (43) Date of publication:<br>**22.12.2004 Bulletin 2004/52** | (51) Int Cl.$^7$: **H03M 13/43**, G06N 3/02 |

(21) Application number: **04004157.6**

(22) Date of filing: **24.02.2004**

| | |
|---|---|
| (84) Designated Contracting States:<br>**AT BE BG CH CY CZ DE DK EE ES FI FR GB GR HU IE IT LI LU MC NL PT RO SE SI SK TR**<br>Designated Extension States:<br>**AL LT LV MK** | (72) Inventor: **Tan, Alfred Keng Tiong, Dr.**<br>**63G Bonham Road Hong Kong (CN)** |
| (30) Priority: **16.06.2003 US 461514** | (74) Representative: **Wihlsson, Joakim Per Magnus**<br>**Bjerkéns Patentbyra KB,**<br>**Östermalmsgatan 58**<br>**114 50 Stockholm (SE)** |
| (71) Applicant: **Go-CDMA Limited**<br>**Kwun Tong, Kowloon, Hong Kong (CN)** | |

(54) **Applications of a multinomial representation of non-linear threshold functions**

(57)    A method and apparatus for optimizing signal detection, multiplexing and demultiplexing with error correction coding, artificial neural network signal processing, and for the combination of linear and non-linear coding/decoding is disclosed, which make use of the multinomial representation of hard threshold non-linear summation functions of arbitrary binary inputs. A method of deriving the complete multinomial represen- tation of these hard threshold non-linear summation functions of arbitrary binary inputs is disclosed and the ability to derive these multinomial representation al- lowed for the optimization of the signal processing in the aforementioned applications, and other applications us- ing such types of hard threshold non-linear summation functions of arbitrary binary inputs.

EP 1 489 749 A2

**Description**

## CROSS-REFERENCE TO PENDING APPLICATION:

This application makes reference to an invention detailed in a pending U.S. provisional patent application entitled "Methods of Optimizing the Decoding of Signals based on a Complete Majority Logic Representation" filed on June 17, 2002 (attached hereto as Appendix A) and referred to as the provisional patent application and provisional patent filing.

## FIELD OF THE INVENTION:

The present invention relates generally to the optimum decoding of signals based on a complete majority logic representation and, more specifically, to using the complete majority logic representation in applications in the areas of, but not restricted to, signal hard threshold detection, signal multiplexing and de-multiplexing, signal processing in artificial neural networks, and combined linear and non-linear signal coding and decoding.

## BACKGROUND OF THE INVENTION:

Conventionally, majority logic and other comparable non-linear functions for the sum of binary data, such as the *sigmodial* functions used in artificial neural networks, are considered hard threshold or input squashing/activation functions because these non-linear functions render their inputs into fixed output ranges. In many cases, signal decoding based on such hard threshold non-linear functions results in a loss of signal energy which reduces their effectiveness for certain applications. In other cases, such hard threshold non-linear functions are discontinuous and non-differentiable, thus, rendering them less useful for use as squashing/activation functions for artificial neural networks.

By way of definition, a function is differentiable if the right hand side of the equation in the function is a variable of which the function is differentiated against. For example, $y = x$ is differentiable by $x$, where $\frac{dy}{dx} = 1$, but $y = 1$ is non-differentiable as the right hand side of the equation is a constant number. A function is continuous, if and only if, there exist a value for the function throughout the entire range of the function. For example, if a function has a range between -1 and +1, then the function is continuous if it exists for all values between the extremities of -1 and +1.

Consider the following non-linear functions for the sum of binary data. One such typical non-linear hard threshold function is the *sign* function, where

$$sign(x) := \begin{cases} 1 & \text{if} \quad x > 0 \\ 0 & \text{if} \quad x = 0, \\ -1 & \text{if} \quad x < 0 \end{cases} \qquad (1.1)$$

where $x$ is the input signal, or, sum of $n$ input signals when

$$x = \sum_{i=1}^{n} x_i \,.$$

Alternatives to the *sign* function in (1.1) are

$$sign_+(x) := \begin{cases} 1 & \text{if} \quad x > 0 \\ 1 & \text{if} \quad x = 0, \\ -1 & \text{if} \quad x < 0 \end{cases} \qquad (1.2)$$

and

$$sign_-(x) := \begin{cases} 1 & \text{if} \quad x > 0 \\ -1 & \text{if} \quad x = 0. \\ -1 & \text{if} \quad x < 0 \end{cases} \qquad (1.3)$$

From the non-linear functions in (1.1), (1.2) and (1.3), the following is apparent:

- These non-linear hard threshold functions can take in an arbitrary sum of inputs but produce only outputs in two or three discreet fixed values.
- For a given sum of arbitrary inputs, which can be greater or less than the fixed output values of the non-linear hard threshold functions, the output of these functions is always one of the two or three discreet fixed values. Hence, this results in a loss in signal information and energy.
- These non-linear hard threshold functions are non-continuous and non-differentiable (due to the fact that the output of these functions is not a variable of their inputs). For example, in (1.2) the output of $sign_+(x)$ is an integer of value +1 or - 1, which is not a function of $x$.

Because of the loss in signal information and energy, any signal passed thorough a hard threshold function would constitute a hard decision being made. In communications systems and information theory, a hard decision process is generally regarded as a process where signal energy up to 2 decibels is loss compared to a soft decision process. A soft decision process is where no hard threshold function is applied on the given input or sum of input signals. It is because of this difference in detected signal information and energy that soft decision signal decoding is usually the preferred option over hard decision signal decoding, although the latter usually requires simpler hardware architecture.

The non-linear sign function may be used to multiplex and de-multiplex more than one channel of data for transmission. For example, in some prior patent filings by the inventor of the current patent filing, namely patent filings entitled "Method and apparatus for non-linear code-division multiple access technology", "Method and apparatus for non-linear code-division multiple access technology with improved detection algorithms and error correction coding" and "Method and apparatus for spread spectrum communication systems using non-linear code words", the non-linear functions $sign$ and $sign_\pm$ have been used in coding schemes which encompass spread spectrum spreading and error corrections in wireless communication systems.

In artificial neural networks, the most natural representation of an squashing/activation function in a neural cell is the "0-1 *step*" function. A "0-1 *step*" function is a representation of the *sign* function within the domain of binary {0,1}. A "0-1 *step"* function is

$$sign(x) := \begin{cases} 1 & \text{if} \quad x > 0 \\ 0 & \text{if} \quad x < 0 \end{cases}. \qquad (1.4)$$

From (1.4) we can see that a "0-1 *step"* function is the same as the *sign* function of (1.1) except for the case where $x = 0$ is undefined. In artificial neural networks, it is required to calculate the gradient of the squashing/activation function at each iteration step of the learning process. Therefore, the squashing/activation function must be continuous and differentiable. However, because of the discontinuity and the fact the *sign* function as represented in (1.4) is not differentiable, the *sign* function not suitable for implementations of artificial neural networks. Alternative squashing/activation functions such as the *sigmodial* function are used instead. A *sigmodial* function is defined as

$$sigmodial\ (x) = \frac{1}{1 + e^{cx}}, \qquad (1.5)$$

where $c$ is a constant determining the slope of the sigmodial function. This function is continuous and differentiable. However, the trade off is that the use of such *sigmodial* squashing/activation function may result in cases where local minima appear where they did not for the cases using a "0-1 *step"* as the squashing/activation function. Over the years a variety of different learning algorithms have been developed with the objective of reaching the global minima in the quickest time, and avoiding, if possible, the appearance of local minima.

In the context of artificial neural networks, a squashing/activation function is the function responsible for turning the input signals going into an artificial neural network neuron into the decision signal transmitted from the output of the same neuron.

Prior to the referenced provisional patent filing, entitled "Methods of Optimizing the Decoding of Signals based on a Complete Majority Logic Representation", the *sign* function in (1.1) was represented in multinomial form as

$$sign\left(\sum_{i=1}^{n} x_i\right) = \rho_1 \sum_{i=1}^{n} x_i + \rho_2 \sum_{\text{all } i>j} x_i x_j + \ldots + \rho_n \prod_{i=1}^{n} x_i, \qquad (1.6)$$

where

$$\rho_1 = \begin{cases} 2^{1-n}\begin{pmatrix} n-1 \\ \dfrac{n-1}{2} \end{pmatrix}, & \text{if } n \text{ is odd,} \\[3em] 2^{-n}\begin{pmatrix} n \\ \dfrac{n}{2} \end{pmatrix}, & \text{if } n \text{ is even,} \end{cases} \qquad (1.7)$$

and

$$\rho_n = \begin{cases} -\rho_1 & \text{if } n+1 \text{ is a multiple of 4,} \\ \rho_1 & \text{if } n+1 \text{ is not a multiple of 4,} \end{cases} \qquad (1.8)$$

and

$$|\rho_i| < \rho_1 \qquad \text{for } i = 2,3,\ldots,n\text{-1}. \qquad (1.9)$$

Also conventionally, for all odd values of $n$, all $\rho_i$ with even subscripts were said to vanish.

Therefore, the conventional multinomial representation for the *sign* function of (1.1) is incomplete. The equations from (1.6) to (1.9) are incomplete because of the following missing elements:

1. We only know that (1.6) exists for the *sign* function of (1.1) and not other similar types of non-linear functions;
2. From (1.7) to (1.9), we only know about how to derive the values of the coefficients for $\rho_1$ and $\rho_n$, but not for all the other coefficients $\rho_i$, where $i =\{0,2,3,\ldots n\text{-}1\}$;
3. We do not know the values for all the coefficients $\rho_i$, where $i = \{0, 2, 3, \ldots, n\text{ -}1\}$, in all cases for both odd and even values of $n$; Because the conventional multinomial representation of the non-linear *sign* function was incomplete, its actual use in hard threshold decoding, data signals multiplexing and de-multiplexing, and better artificial neural network squashing/activation functions has been limited or non-existent.

Prior to the disclosure of the provisional patent application filing the complete multinomial representation of a non-linear function such as that of (1.1), and others such as (1.2) and (1.3), and the *sigmodial* function of (1.5) was unknown.

Accordingly, there is a need for a complete multinomial representation of non-linear functions such as the sign function, the sigmodial function and others such as equations 1.2 and 1.3. There is a further need to improve decoders, artificial neural networks and other systems by implementing non-linear functions within systems that are based on a complete multinomial representation.

## SUMMARY OF THE INVENTION:

According to the present invention, the complete multinomial representation of all the aforementioned non-linear functions given as

$$sign_*\left(\sum_{i=1}^{n} x_i\right) = \rho_0 + \rho_1 \sum_{i=1}^{n} x_i + \rho_2 \sum_{\text{all } i>j} x_i x_j$$
$$+ \rho_3 \sum_{\text{all } i>j>k} x_i x_j x_k + \ldots + \rho_n \prod_{i=1}^{n} x_i, \qquad (1.10)$$

where $* \in \{+,-,\}$, as (1.10) represents more than just the typical *sign* non-linear function.

To reinforce an important point at this juncture, the embodiments of the present invention are based on the complete derivation of the multinomial representation of non-linear functions of (1.1), (1.2), (1.3), (1.4), (1.5) and any functions for sum of arbitrary binary input data can be represented in a complete multinomial representation, as shown in(1.10). Unlike the incomplete multinomial representation of (1.6) given in the prior art, the invention presented in the referenced provisional patent also details the complete derivation of the $\rho_i$, where $i = 0,1, 2,..., n$, for all the aforementioned non-linear functions, for both odd and even values of n.

According to one embodiment of the present invention, an improved signal detection scheme using the non-linear hard threshold functions is proposed, where there is no, or very little loss in received signal energy or information.

In yet another embodiment of the present invention, a signal coding, multiplexing, and de-multiplexing, iterative decoding scheme using concatenated block and convolutional or Turbo codecs, together with spread spectrum spreading is proposed.

In another embodiment of the present invention, a differentiable signal squashing/activation function for the use in artificial neural networks based on the non-linear threshold *sign* function is proposed.

In a further embodiment of the present invention, a method of coding and decoding of signals comprising of the derivation for the parity bits for the composite signal, coding the parity bits based on a linear coding function, followed by the coding of the composite signal and its parity bits based on a non-linear hard threshold function, and transmission of the resultant coded signal, for decoding at the receiver end, which entails both the non-linear function and a linear decoding function.

## BRIEF DESCRIPTION OF THE FIGURES:

The above described features and advantages of the present invention will be more fully appreciated with reference to the detailed description and appended figures, in which:

Figure 1 depicts a flow diagram depicting the use of multinomial representation of non-linear hard threshold functions to improve the detection of a "hard decision" signal detection scheme.

Figure 2 depicts a block diagram depicting an embodiment of the present invention, where the multinomial representation of a non-linear function is used in a data signal multiplexing/de-multiplexing together with serially concatenated error correction decoding.

Figure 3 depicts a 1/3 Turbo encoder for an example in the implementation of a data signal multiplexing/de-multiplexing together with serially concatenated error correction decoding.

Figure 4 depicts a block diagram example of the transmitter in the example in the implementation of a data signal multiplexing/de-multiplexing together with serially concatenated error correction decoding.

Figure 5 depicts a block diagram example of the receiver in the example in the implementation of a data signal multiplexing/de-multiplexing together with serially concatenated error correction decoding.

Figure 6 is a flow diagram depicting the use of multinomial representation of non-linear hard threshold functions in deriving an improved signals multiplexing and de-multiplexing scheme with a serially concatenated iterative decoding architecture.

Figure 7 is a flow diagram depicting the use of multinomial representation of non-linear hard threshold functions as artificial neural network squashing/activation functions.

Figure 8 is a flow diagram depicting the use of multinomial representation of non-linear hard threshold functions in a novel combination of linear and non-linear coding and decoding functions for signal communication.

Figure 9 is a flow chart depicting the steps taken in the complete derivation of the multinomial representation of the non-linear functions utilized in this patent.

**DETAILED DESCRIPTIONS:**

**I. Overview**

The complete majority logic representation of equations such as 1.1, 1.2, 1.3 and 1.5, set forth in the summary of the invention section, is further described below applied in applications for better signal detection, signal multiplexing and coding, together with de-multiplexing and iterative decoding, use in improvements for artificial neural networks signal processing, and finally, a novel combined linear and non-linear signal coding and decoding scheme.

**II. A "hard decision" signal detection scheme using the multinomial representation of the non-linear hard threshold functions**

An embodiment of the present invention is a hard decision based signal detection scheme that exploits the multinomial representation of the non-linear hard threshold functions of (1.1), (1.2), (1.3), (1.4), (1.5) and any functions for sum of arbitrary binary input data can be represented in a complete multinomial representation.

To illustrate this embodiment, we shall take the example of hard threshold signal decoding for 3 parallel streams of bipolar data $\alpha$, $\beta$ and $\gamma$, multiplied to 3 mutually orthogonal signals, namely, $x1$, $x2$ and $x3$, where

$$x1 = \begin{bmatrix} 1 & -1 & 1 & -1 \end{bmatrix};$$
$$x2 = \begin{bmatrix} 1 & 1 & -1 & -1 \end{bmatrix}; \qquad (1.11)$$
$$x3 = \begin{bmatrix} 1 & -1 & -1 & 1 \end{bmatrix};$$

and the signal to be received after transmission through a channel is

$$x = \alpha \bullet x1 + \beta \bullet x2 + \gamma \bullet x3 + N, \qquad (1.12)$$

where $N$ is noise in the system.

The conventional "hard decision" approach to decoding the received signal $x$ in (1.12) is

$$\hat{\alpha} = sign\left( \int_{t_0}^{t_3} x1 \bullet x\, \partial t \right);$$
$$\hat{\beta} = sign\left( \int_{t_0}^{t_3} x2 \bullet x\, \partial t \right); \qquad (1.13)$$
$$\hat{\gamma} = sign\left( \int_{t_0}^{t_3} x3 \bullet x\, \partial t \right);$$

where $t_0$ to $t_3$ represents the bit timing of the orthogonal signature bit patterns of $x1$, $x2$ and $x3$, and, $\hat{\alpha}$, $\hat{\beta}$ and $\hat{\gamma}$ being the estimated values of the transmitted data $\alpha$, $\beta$ and $\gamma$. $a \bullet b$ is arithmetic dot product of $a$ and $b$. With (1.13), signal is lost when the hard threshold $sign$ function is used to determine the estimated values for $\alpha$, $\beta$ and $\gamma$. If a hard threshold decision must be made of the received signal $x$ in (1.12), then a better approach in hard threshold decoding is

$$x' = sign\ (x), \qquad (1.14)$$

and,

$$\hat{\alpha} = \int_{t_0}^{t_3} x1 \cdot x' \, \partial t;$$

$$\hat{\beta} = \int_{t_0}^{t_3} x2 \cdot x' \, \partial t;$$

$$\hat{\gamma} = \int_{t_0}^{t_3} x3 \cdot x' \, \partial t;$$  (1.15)

$$\hat{\alpha} \cdot \hat{\beta} \cdot \gamma = \int_{t_0}^{t_3} x1 \cdot x2 \cdot x3 \cdot x' \, \partial t;$$

where $\hat{\alpha} \cdot \hat{\beta} \cdot \hat{\gamma}$ is an additional parity of the transmitted data bits $\alpha, \beta$ and $\gamma$, resulting from the multinomial representation of $x'$. In accordance to an embodiment of the present invention,

$$x' = sign\ (x) = \frac{1}{2}\ (\alpha \cdot x1 + \beta \cdot x2 + \gamma \cdot x3) - \frac{1}{2}\ (\alpha \cdot \beta \cdot \gamma \cdot x1 \cdot x2 \cdot x3) + N \qquad (1.16)$$

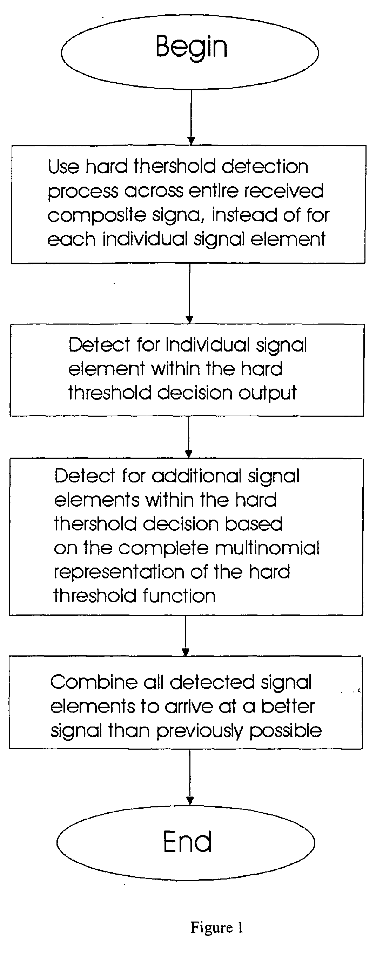

The additional signal from the parity $\alpha \cdot \beta \cdot \gamma$ in (1.15) is only possible due to the ability to fully derive the multinomial representation of $x' = sign\ (x)$ with an embodiment of the present invention. By comparing (1.12) and (1.15) we can observe that with the knowledge of the multinomial representation of the hard threshold function *sign* we can arrive at an improved "hard decision" signal detection scheme.
A flow diagram summarizing the current embodiment is given in Figure 1.

### III. An improved signals multiplexing and de-multiplexing scheme with a serially concatenated iterative decoding architecture

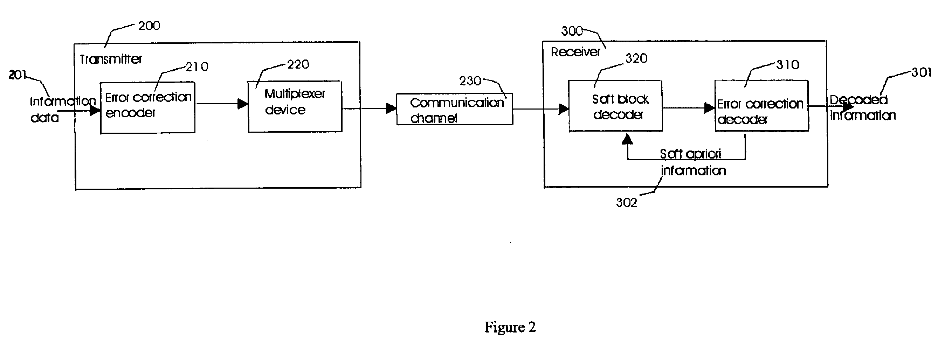

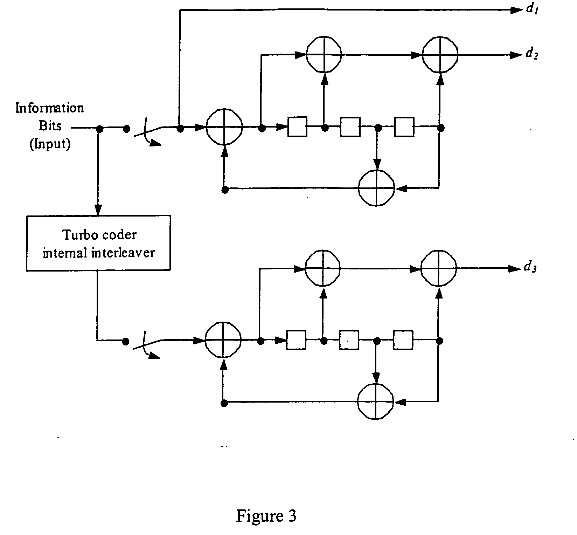

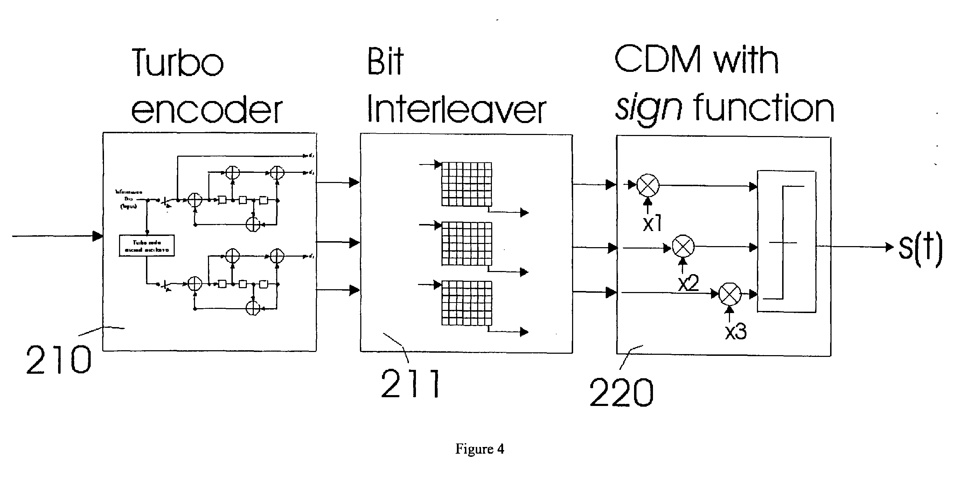

An embodiment of the present invention is an improved signals multiplexing and de-multiplexing scheme with a serially concatenated iterative decoding architecture.
In this embodiment of the present invention, the proposed scheme uses a hard threshold *sign* function at the transmitter equipment to multiplex the data streams from the channel error-correction coding device prior to transmission over the channel. At the receiver equipment, the de-multiplexing process involves a decoding device that is serially concatenated to another channel error correction decoding device. The two decoding devices decode the received data in an iterative manner in an effort to minimize the error in the received data.
To illustrate this embodiment of the present invention, we refer to the transmitter 200 in Figure 2. In this figure, the information data 201 is first channel encoded by the channel error correction encoder device 210, and then multiplexed by the multiplexer device 220 before being transmitted into the communication channel 230. At the receiver 300, the received data is decoded in a soft block decoder 320 before further decoded by the channel error correction decoder 310. Both the soft block decoder 320 and channel error correction decoder 310 iteratively decodes and shares soft apriori information 302 between them to further improve the accuracy of the decoded information 301. To better illustrate this embodiment of the present invention, the channel error correction encoder 210 shall be a rate 1/3 Turbo code encoder as depicted in Figure 3. This channel error correction encoder can use any error correction scheme including, but not limited to, block coding, convolutional coding, Turbo coding and other parity based error correction coding schemes. In the example of Figure 3, to multiplex the 3 bits, $\{d1, d2, d3\}$, of coded data from the Turbo encoder, we use a code division-multiplexing (CDM) scheme together with a *sign* function. This is depicted in Figure 4. In Figure 4, block numbered 211 is a bit interleaver. To multiplex, using multiplexer block number 220, the 3 bits, $\{d1, d2, d3\}$, coded information from the Turbo encoder we choose to use 3 orthogonal CDM codes, namely $x1$, $x2$ and $x3$, where

$$x1 = a\begin{bmatrix} 1 & -1 & 1 & -1 \end{bmatrix};$$
$$x2 = b\begin{bmatrix} 1 & 1 & -1 & -1 \end{bmatrix}; \qquad (1.17)$$
$$x3 = c\begin{bmatrix} 1 & -1 & -1 & 1 \end{bmatrix};$$

and we used the non-linear hard threshold *sign* function of (1.1). Together with the multinomial expansion as presented in an embodiment of the present invention, the multiplexed signal $s(t)$ in the proposed example is then

$$s(t) = sign\left(\begin{bmatrix} d1 & d2 & d3 \end{bmatrix}\begin{bmatrix} x1 \\ x2 \\ x3 \end{bmatrix}\right);$$ (1.18)

$$= \frac{1}{2}(d1 \bullet x1 + d2 \bullet x2 + d3 \bullet x3) - \frac{1}{2}(d1 \bullet d2 \bullet d3 \bullet x1 \bullet x2 \bullet x3).$$

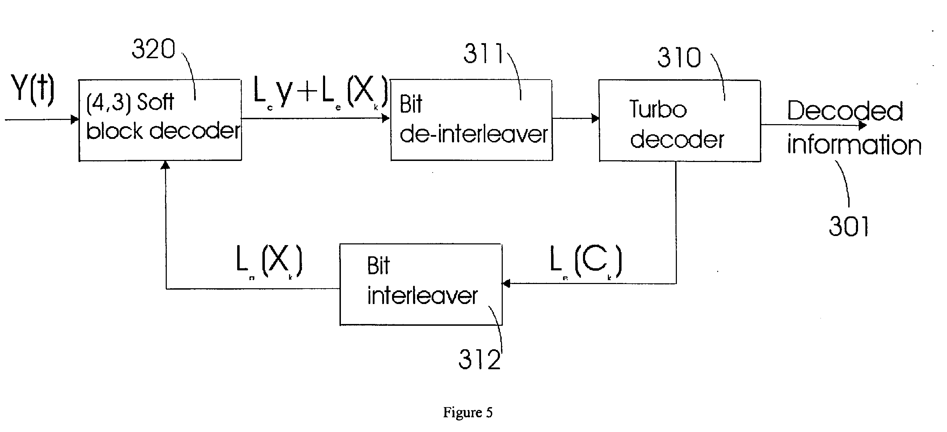

A "priority weighting" scheme can also be assigned for the different data channel at the multiplexing point of the CDM. This is done by giving a priority weight for *a*, *b*, *c* in equation (1.17) according to their importance. The way to calculate this priority weighting is given in the prior art, otherwise all multiplexed channels are set as equal. The multiplexed signal *s*(*t*), is then transmitted in the communication channel. At the receiver end, as depicted in Figure 5, the embodiment of the present invention proposed an innovative approach to the de-multiplexing of the received signal, where the multiplexing process is treated as a coding process. As such, at the receiver, a soft block decoder is used to de-multiplex and decode the multiplexed signal. In the example of Figure 5, the soft block decoder is numbered 320, and decodes the received signal using a soft block decoding approach similar to the approach described in prior art, which described a soft block decoding process for iterative binary block and convolutional coding.

In reference to Figure 5, assuming for the case where the multiplexer 220 in Figure 3, multiplexed the *d*1, *d*2, *d*3 interleaved, coded inputs into *s(t)*, where the output after the communication channel *y(t)* = *y*1, *y*2, *y*3, *y*4 is a stream of 4 bits spread spectrum outputs. At the receiver 300, as depicted in Figure 5, these 4 bits spread spectrum outputs is received into a (4,3) soft block decoder, numbered 320 in Figure 5, constructed according to the general principals as described in the prior art. The output from the (4,3) soft block decoder, numbered 320 in Figure 5, are logarithmic values $L(X_1)L(X_2)L(X_3)$, where

$$L(X_k) = L_c y + L_a(X_k) + L_e(X_k), \qquad k \in \{1,2,3\}$$ (1.19)

and $L_c y$ is the logarithmic soft channel value, where $L_c y = 4\frac{E_c}{N_0}$ with $E_c$ being energy per transmission chip in *s*(*t*) and $N_0$ being the energy of white gaussian noise. In equation (1.19), $L_a(X_k)$ is the logarithmic apriori information (numbered 302 in Figure 4) received from the Turbo decoder (numbered 310 in Figure 4). In the same equation, $L_e(X_k)$ is the extrinsic logarithmic information generated by the (4,3) soft block decoder 320. As noted in Figure 5, the information $L(X_k)$ passed onto the bit-wise de-interleaver, numbered 311 in Figure 5, is stripped of their $L_a(X_k)$ values as it is the principal of iterative decoding to pass only previously unknown information to a decoding component. The Turbo decoder numbered 310 in Figure 5, will be engaged in the Turbo decoding process, except that it does not pass out the decoded information 301 at the end of its own internal iterative decoding, unless it is at the completion of both the inner and outer iterative decoding cycle for the block of data received. An inner iterative decoding cycle refers to the iterative decoding cycle within the Turbo decoder and an outer iterative decoding cycle refers to the iterative decoding cycle between the soft block decoder 320 and the Turbo decoder 310. In this example for the embodiment of the present invention, the decoding process involves both the inner and outer cycle iterative decoding, with the final iteration being the inner cycle iteration at the error correction decoder 310. Note, that for other implementations of the present embodiment, where the error correction decoder does not require any iterative decoding, the only cycle of iterative decoding is the outer cycle iterative decoding, where the iteration is between the soft block decoder in 320 and the error correction decoder block in 310.

While not at the completion of both the inner and outer iterative decoding cycles, the Turbo decoder numbered 310 in Figure 5, will pass out extrinsic logarithmic values of coded bits $L_e(C_k)$, which include the apriori logarithmic information generated within the Turbo decoder and the extrinsic logarithmic information generated by the Turbo decoder (but not the extrinsic logarithmic information $L_e(X_k)$ received by the Turbo decoder from the soft block decoder previously) back to the soft block decoder numbered 320. Before passing the extrinsic logarithmic values of coded bits $L_e(C_k)$ to the soft block decoder 320 (which will view them as apriori logarithmic information $L_a(X_k)$), these information bits are passed through a bit-wise interleaver, numbered 312 in Figure 5, identical to the interleaver block numbered 211 in Figure 4.

At the soft block decoder, these apriori logarithmic information $L_a(X_k)$ will be used in the iterative decoding process to generate the next iteration of extrinsic logarithmic information $L_e(X_k)$ for the next cycle of decoding at the error correction decoder in 310.

At the completion of both the inner and outer iterative decoding cycles, the decoded information (numbered 301) would be outputted from the Turbo decoder (numbered 310).

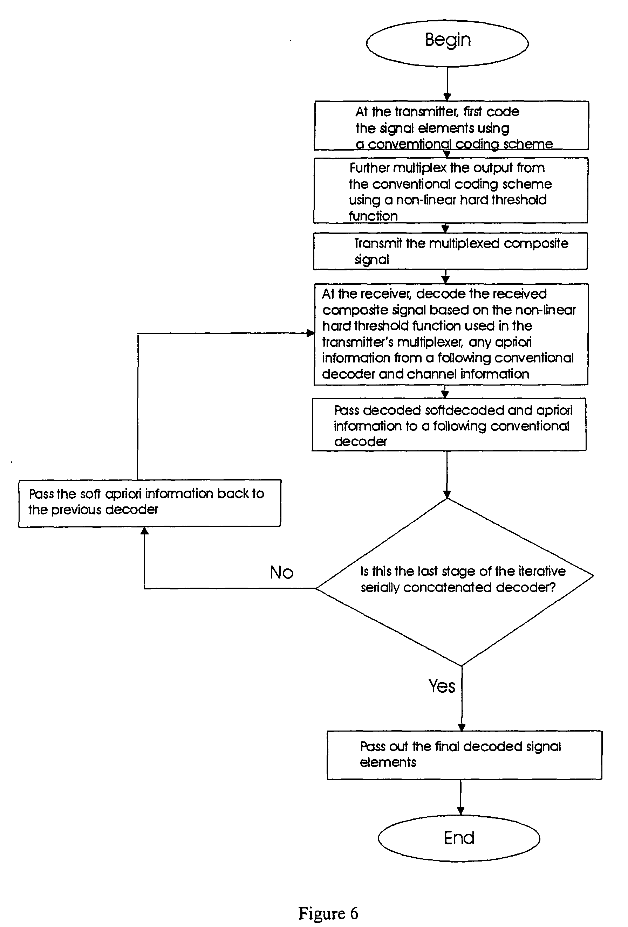

An embodiment of the present invention is in the implementation of a multiplexing process that is also a coding process, which is only possible with the complete multinomial representation of the non-linear hard decision functions introduced in this patent, and to use this implementation in an iterative decoding manner at the receiver, which both accomplishes the tasks of de-multiplexing and providing additional error correction protection in one setting. It is also noted here that in some communication systems, such multiplexing and de-multiplexing schemes are often referred to as channel spreading and de-spreading. As such, the embodiment of the present invention also applies to the use in these channel spreading and de-spreading schemes. A flow diagram summarizing the current embodiment is given in Figure 6.

**IV. Artificial neural network squashing/activation functions using a non-linear hard threshold function and its multinomial expansion**

An embodiment of the present invention is in the use of the non-linear hard threshold functions, such as the *sign* function or the $sign_\pm$ functions, as the squashing/activation function in artificial neural networks. While, such functions, as the function shown in (1.4), were used as squashing/activation functions in prior arts, their use has since been discarded due to the fact that they are non-differentiable, where being differentiable is an important feature in the learning process of an artificial neural network. In an embodiment of the present invention, the non-linear hard threshold $sign_*$ function, as shown in (1.4), with their respective multinomial representation, as described in referenced provisional patent filing, is used as the squashing/activation functions in artificial neural network.

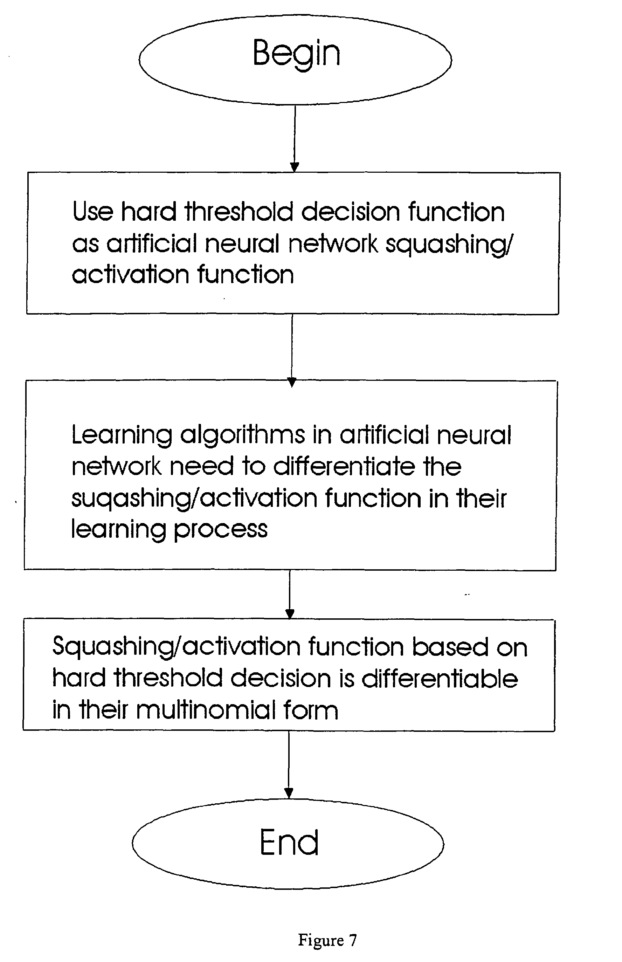

The multinomial expansion of the $sign_*$ function as described in an embodiment of the present invention allows these non-linear hard threshold functions to be differentiable, thus, enabling for the learning process in artificial neural networks. This embodiment of the present invention is significant due to the fact that squashing/activation functions using such non-linear hard threshold functions do not introduce the problem of local minima, which otherwise would have existed in artificial neural networks using other squashing/activation functions such as the *sigmodial* function of (1.5). A flow diagram summarizing the current embodiment is given in Figure 7.

**V. A novel combination of linear and non-linear coding and decoding functions for signal communication**

Another embodiment of the present invention is in the use of both linear and non-linear coding functions in the coding and decoding process for a transmission of a composite signal over a transmission link. In this embodiment, linear coding functions are used together with non-linear majority logic coding functions, as the use of such a combination will further enhance the strength of the non-linear majority logic coding functions via the use of linear coding functions. An example of an application of such an embodiment is as illustrated in the referenced provisional patent filing, where linear parity coding is used to code the 3 data streams prior to non-linear majority logic coding. This result in a parallel stream of 8 inputs into the non-linear majority logic coder, namely 3 original parallel data inputs and 5 parity bits derived from these 3 data bits. The output of the non-linear majority logic coder is then transmitted over a communication channel and at the decoder, the received data stream is first majority logic decoded, followed by linear parity decoding. It is shown in that example that the strength of the 8 inputs majority logic coding/decoding scheme is boosted to the equivalence of a 3 inputs majority logic coding/decoding scheme, just by the use of linear parity coding logics.

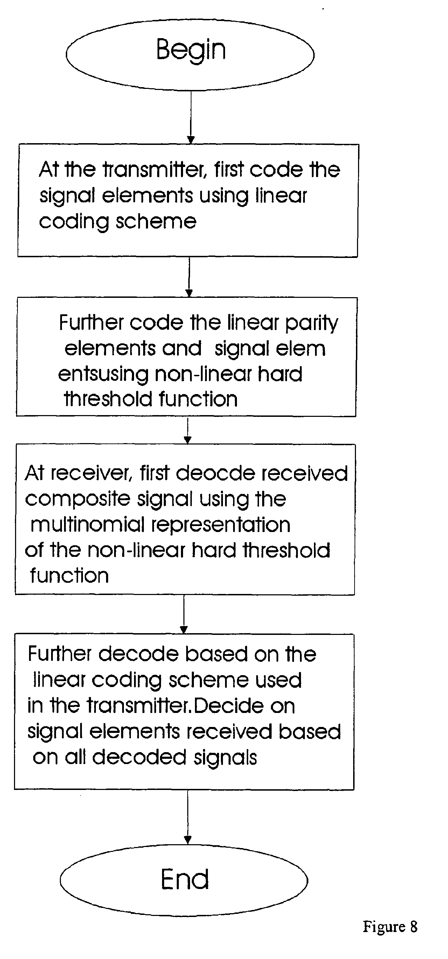

An application of this is in the majority logic coding of 5 parallel input data streams. Prior arts have indicated that this will introduce intrinsic errors, where such errors are due to the coding scheme. This problem can be solved with the current embodiment of the present invention. To solve this problem, we can further derive 3 linear parity logic coded bits from the original 5 data bits. Then, we can use 8 parallel inputs majority logic coding/decoding scheme, which will give us the net coding strength effect of a 5 parallel inputs majority logic coding/decoding scheme, without the problems of intrinsic errors. Examples of linear logic coding schemes and majority logic coding/decoding scheme are well illustrated in the referenced provisional patent filing and other prior arts, and will not be repeated herein. A flow diagram summarizing the current embodiment is given in Figure 8.

**VI. Selection of multinomial representation based on the non-linear hard threshold function used**

As highlighted in the referenced provisional patent filing, the final multinomial representation of the non-linear hard threshold function is depended on the type of non-linear hard threshold function used. This is clearly illustrated in the referenced provisional patent filing and some examples of different multinomial coefficients, $\rho_i$, where $i = \{0,1,2,3,...,n\}$, are given in Tables 1 and 2 in the references for the referred provisional patent filing.

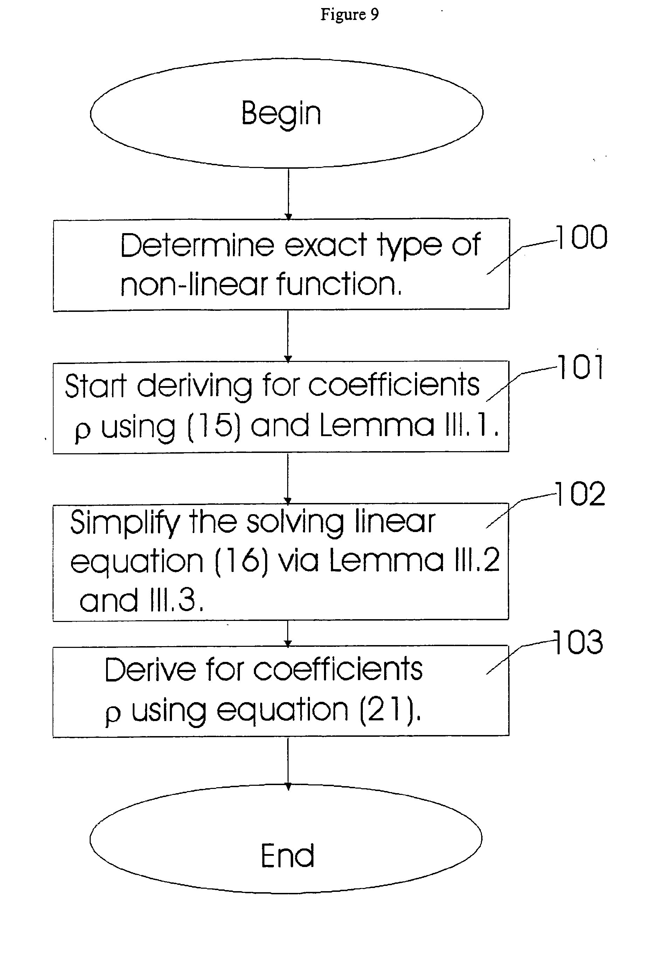

To further summarize, a flow chart on the steps taken to derive the complete multinomial representation of equation (1.10) is presented in Figure 9. In brief, the derivation of the multinomial representation of equation (1.10) begins with the determination of the exact type of non-linear function represented by equation (1.10) - process 100. Then, we can derive for the coefficients ρ using equation (15) and Lemma III.1 from the cited reference of the referred provisional patent. This is process 101 in Figure 2. As Lemma III.1 states that the coefficients ρ can be found via solving the linear equation (16) from the cited reference of the referred provisional patent, we shall proceed with Lemma III.2 from the same citation, which was proven with Lemma III.3, also from the same citation. Lemma III.2, together with Lemma III.3, showed us that we could use the involutary property of $R_{n+1}$ to arrive at a simple solution, which allows us to derive for all values for the coefficients of ρ . This is step 102 in Figure 9. Finally we arrive at step 103, Theorem III.1, which tells us that we can derive for all coefficients ρ by using equation (21) from the cited reference of the referred provisional patent.

While specific embodiments of the present invention have been disclosed, it will be understood by those having ordinary skill in the art that changes may be made to those embodiments without departing from the spirit and scope of the invention. Furthermore, it will be understood that the signals as referenced in the above embodiments encompass signals representations in all applicable domains including, but not restricted to, time signals, frequency signals, sequency signals, phase signals and spatial signals, and all forms of signals representations including, but not restricted to, continuous signals, discrete signals, real signals and imaginary signals. It will be further understood that the mathematical and matrix operations using the multinomial representation of the aforementioned non-linear hard threshold functions, may be implemented in hardware or software. In the latter case, software instructions and data may be embodied in a computer useable medium and stored in a memory of a communications device. The software instructions may include control logic which when executed by a processor or other hardware cause the communications device to encode and decode data messages based on the multinomial representation of the aforementioned non-linear hard threshold functions. When implemented in hardware or firmware, the mathematical and matrix operations using multinomial representation of the aforementioned non-linear hard threshold functions, may be provided by logic on one or more chips or may be burned into, for example, an EEPROM as program instructions and data. It will be further understood that the multinomial representation of the aforementioned non-linear hard threshold functions, may, for retrieval and use by a system, be stored in a memory, embodied in hardware, received from an external source such as other hardware or memory, or derived or generated from stored data or hardware internal to or external to the system.

## APPENDIX A

# Majority Logic Coding and its Multinomial Representation

John B. Moore* and Keng T. Tan+

### Abstract

Multinomial representations are derived for majority logic operations on bipolar binary data. The coefficients are given simply in terms of the readily computed lower *Cholesky* factor of *Pascal Matrices* of order $n$ for codes of block length $n$.

Sufficient conditions on majority logic codes having no deterministic coding errors are given in terms of the multinomial coefficients and codewords. These are used to guarantee that certain codes based on Hadamard matrices, Rademacher matrices and *pseudo*-random bipolar sequences have no deterministic coding errors.

A novel majority logic coding scheme is proposed which comprises a first stage of linear coding with its own spreading factor, followed by a second stage of majority logic coding with its own spreading factor, and a single stage majority logic decoding to recover the data.

### I. INTRODUCTION

Majority voting on binary data is the basis of certain nonlinear block coding schemes in communication systems [1], especially in the case where, extremely low power radio wave communications is desired [2]. The majority logic operation is used in both the coding and decoding operations. Because of the nonlinearity of the operation, there is difficulty in predicting system performance, or seeing how to improve system performance. A crucial tool in this task is a multinomial representation of the majority logic operation.

A multinomial expansion for majority logic has been partially studied in [3], [4], and the results applied in various communication contexts. General formulas for the first and last coefficients in the expansion are stated, and for bipolar binary vectors of length $n$, it is claimed that the even numbered coefficients are zero for $n$ even, but we know of no sources which give other coefficients.

Here, we first give a complete theory for the multinomial representations of majority logic operations on bipolar binary data. The majority logic operation can be a classic *sign* function of the sum of the binary data, as studied in the earlier literature known to us. Perhaps more usefully, we also give a theory for what we term here $sign_{\pm}$ functions. These are *sign* operations where an output of 0 is replaced by $\pm 1$. The approach extends to other nonlinear functions of the sum of binary data, such as to *sigmoidal functions* used in artificial neural networks. It also extends to arbitrary nonlinear functions of bipolar binary data vectors that are invariant of the order of the data within the vector.

The coefficients of the multinomial expansion are linear in what we call a generalized Pascal matrix, which can be factored in terms of the lower triangular *Cholesky* factor, denoted here $P_n$, of a *Pascal matrix* of order $n$. The 'new' results are generalizations of the classical results. It would not be surprising if at least some of the results were known by Pascal, but the motivation for deriving them, or highlighting them, is coming from applications of nonlinear coding for next generation wireless communications.

The explicit multinomial representations for majority logic are applied first to majority logic based coding and decoding schemes. Such schemes have been proposed in the literature [1], [2], [5], [6], [7], [8], but theory guaranteeing that proposed code classes lead to error free communication in the noise-free channel case has been limited. Here we develop sufficient conditions based on a diagonal dominance condition of matrices derived from a code matrix and the multinomial coefficients. The condition is applied to codes based on Hadamard and Rademacher matrices, and *pseudo*-random PN sequences, leading to new results in some cases.

*Currently a Visiting Professor at the Department of Information Engineering, The Chinese University of Hong Kong from the Department of Systems Engineering, Research School of Information Sciences and Engineering, The Australian National University, Canberra,ACT 0200, Australia, john.moore@syseng.anu.edu.au.The work has partial support from the Earmarked RGC Grant CUHK 4227/00E, as well as the Australian Research Grants Committee.

+GO-CDMA Ltd, 3rd Floor, Winsome House, 73 Wyndham St, Central,Hong Kong , alfred.tan@go-cdma.com

A novel majority logic coding scheme is proposed which comprises a first stage of linear coding with its own spreading factor, followed by a second stage of majority logic coding with its own spreading factor, and a single stage majority logic decoding to recover the data. The first linear stage can be simply an augmentation of parity bits.

In Section II, the new results on multinomial expansions of majority logic functions are derived. In Section III, these results are applied to majority logic based nonlinear block coding. In Section IV, the estimation of partial products of data are presented, and new coding algorithms based on these are proposed in Section V. A diagonal dominance codeword condition and its application is presented in Section VI. In Section VII, numerical results of the schemes analysed in this paper are presented. Conclusions are drawn in Section VIII.

## II. THE PASCAL MATRIX AND A MULTINOMIAL EXPANSION

In this section, we introduce background material and a complete and novel multinomial equation for representing the non-linear functions described in this paper. This section sets up notation for the main results of the following sections.

Our results concern nonlinear operations on a data $n$-vector $a = [a_1, a_2, \ldots, a_n]'$ with $a_i \in \{+1, -1\}$. Now any nonlinear function of $a$ belongs to a finite discrete set of no more than $2^n$ elements. Indeed, such functions are linear in an indicator $2^n$-vector $Y \in \{e_1, e_2, \ldots, e_n\}$, where $e_i$ is a zero $2^n$-vector save that the $i^{th}$ element is unity.

Our new results concern nonlinear operations that are invariant of any ordering in the data, such as functions of $\sum_{i=1}^{n} a_i$, $\prod_{i=1}^{n} a_i$, or of $\prod_{i=1}^{n}(1 + a_i)$. In this case, the functions belong to a discrete set of at most $n + 1$ elements.

Our focus is on (nonlinear) majority logic functions involving *sign* operations on sums of partial products $q$, which map one-to-one to the data vector. The resulting representations are termed multinomial representations.

### A. Multinomial representation for majority logic

*1) Nonlinear functions and majority logic:* Consider the *sign* function definition.

$$sign(x) := \begin{cases} 1 & \text{if } x > 0 \\ 0 & \text{if } x = 0 \\ -1 & \text{if } x < 0 \end{cases}. \tag{1}$$

Let us also introduce derivative definitions, denoted $sign_+$ and $sign_-$ as

$$sign_\pm(x) := \begin{cases} 1 & \text{if } x > 0 \\ \pm 1 & \text{if } x = 0 \\ -1 & \text{if } x < 0 \end{cases}. \tag{2}$$

Consider now a set of $n$ bipolar binary digits $\{a_1, a_2, \ldots, a_n\}$, that is where $a_i \in \{+1, -1\}$. The majority logic operation on this $n$-block of data is simply $sign_*(\sum_1^n a_i)$, where we have used $sign_*$ to denote either $sign$, $sign_+$ or $sign_-$. The latter two options can be used if the output of the logic operation is constrained to be also bipolar binary.

*2) Multinomial representation:* Early literature [3][4], presents a partial multinomial representation for the majority logic *sign* operation. We have discovered the complete multinomial representation, which applies generally to $sign$, $sign_+$, $sign_-$, sigmoidal and other non-linear functions described in this paper, together with techniques for calculating coefficients that were previously unknown. Here we mildly generalize our multinomial representation as

$$sign_* \left( \sum_{i=1}^{n} a_i \right) = \rho_0 + \rho_1 \sum_{i=1}^{n} a_i + \rho_2 \sum_{\text{all } i > j} a_i a_j$$
$$+ \rho_3 \sum_{\text{all } i > j > k} a_i a_j a_k + \ldots + \rho_n \prod_{i=1}^{n} a_i. \tag{3}$$

for suitable selections of coefficients $\rho := [\rho_0, \rho_1, \ldots, \rho_n]'$, which will depend on which of the *sign* operations is used. The selection of the coefficients and their properties is the study of this paper.

Of course, the expansion of the nonlinear function $\prod_{i=1}^{n}(1 + a_i)$ has such an expansion as the right hand side of (3) with coefficients $\rho = [1 \ 1 \ldots 1]$. The mapping from the set $\{a_i\}$ to the set of the sums of products in (3) via the coefficients of the $\rho_i$, is known to be one to one.

12

The earlier work has given specific formulas for the coefficients $p_0, p_1, p_n$ of (3) in terms of permutation operations $^nC_i = \frac{n!}{i!(n-i)!}$, at least for the case of the classic $sign$ function. It is also noted in the early work that in this case $p_i = 0$ for $n, i$ even, but other coefficients have not been studied to our knowledge.

In our applications of such expansions, it is important to have readily calculated coefficients for all the coefficients $p_i$, and to see relationships between them in order to understand experimentally observed relationships in majority logic coding for communication systems.

In order to proceed, we first review relevant results of the Pascal matrix.

### B. The lower Cholesky factor of the Pascal matrix

The well known (second) Pascal matrix, is a lower $Cholesky$ factor of the original (first) Pascal matrix. We will refer to this (second) Pascal matrix simply as the $Pascal\ matrix$, and use the notation $P_n = (p_n^{i,j})$ for such an $n \times n$ matrix. Its elements, for $i, j = 1, 2, \ldots, n$ are defined in terms of the binomial coefficients , so that the $i, j$ element for $i \leq j$ is

$$p_n^{i,j} = [(-1)^{j-1} \cdot {}^{i-1}C_{j-1}] := \frac{(-1)^{j-1}(i-1)!}{(j-1)!(i-j)!}, \text{ for } i \geq j. \tag{4}$$

The key property which we exploit subsequently is that $P_n$ is $involutary$ in that

$$P_n = P_n^{-1}, \quad P_n P_n = I_n. \tag{5}$$

We see that $P_n$ has the form,

$$P_n = \begin{bmatrix} 1 & 0 & 0 & 0 & 0 & 0 & \cdot & & \cdot \\ 1 & -1 & 0 & 0 & 0 & 0 & \cdot & & \cdot \\ 1 & -2 & 1 & 0 & 0 & 0 & \cdot & & \cdot \\ 1 & -3 & 3 & -1 & 0 & 0 & \cdot & & \cdot \\ 1 & -4 & 6 & -4 & 1 & 0 & \cdot & & \cdot \\ \cdot & \cdot & \cdot & \cdot & \cdot & \cdot & \cdot & & \cdot \\ {}^{(n-1)}C_0 & {}^{(n-1)}C_1 & {}^{(n-1)}C_2 & \cdot & \cdot & \cdot & \cdot & {}^{(n-1)}C_n \end{bmatrix}. \tag{6}$$

$Pascal's\ equation$ allows an alternative construction for $P_n$ as,

$$\begin{aligned} p_n^{1,1} &:= 1; \\ p_n^{2,1} &:= 1; \\ p_n^{2,2} &:= -1; \\ p_n^{i+1,j} &:= p_n^{i,j} - p_n^{i,j-1}, \text{ for } i = 3, 4, \ldots, n; \\ p_n^{i,j} &:= 0, \text{ for } i = j+1, j+2, \ldots, n. \end{aligned} \tag{7}$$

Indeed, this recursion allows an induction argument to readily confirm the involutary property of $P_n$.

### III. MULTINOMIAL COEFFICIENTS

To lead into the derivations of our main results, consider the polynomials $(s-1)^i$ for $i = 0, 1, 2, \ldots, n$ for some nonnegative integer $n$ and scalar $s$, organized as

$$\begin{bmatrix} (s-1)^0 s^n \\ (s-1)^1 s^{n-1} \\ \cdot \\ \cdot \\ (s-1)^n s^0 \end{bmatrix} = P_{n+1} \begin{bmatrix} s^n \\ s^{n-1} \\ \cdot \\ \cdot \\ s^0 \end{bmatrix}. \tag{8}$$

Now consider the multinomial (3) for all possible polar binary sequences $\{a_1, a_2, \cdots, a_n\}$. Clearly, the expansion is invariant of the ordering of the $a_i$, so that there are only $n+1$ selections, namely where there are $k = 0, 1, 2, \cdots, n$ values of $a_i = 1$, with correspondingly $n - k = 0, 1, \cdots, n$ values of $a_i = -1$. Indeed the terms involving sums of products of the $a_i$ in (3) are given, for each $k = 0, 1, 2, \cdots, n$, as the coefficients of the expansion $(s-1)^k (s+1)^{n-k}$.

*A. A generalized Pascal matrix*

A useful generalization of (8) is then

$$\begin{bmatrix} (s-1)^0(s+1)^n \\ (s-1)^1(s+1)^{n-1} \\ \cdot \\ \cdot \\ (s-1)^n(s+1)^0 \end{bmatrix} = R_{n+1} \begin{bmatrix} s^n \\ s^{n-1} \\ \cdot \\ \cdot \\ s^0 \end{bmatrix} \tag{9}$$

for some readily calculated $(n+1) \times (n+1)$ matrix $R_{n+1} := (r^{i,j})$ consisting of elements $r^{i,j}$, and termed here a *generalized Pascal matrix*. In particular, the $i^{th}$ row of $R_{n+1}$ consists of the sums of products of the $a_i$ in (3), for $k$ values of $a_i = 1$, with correspondingly $n - k$ values of $a_i = -1$, and are the coefficients of the polynomial $(s-1)^k(s+1)^{n-k}$.

For reference, the cases for $n = 1, 2, 3, 4$ are spelt out as,

$$R_2 = \begin{bmatrix} 1 & 1 \\ 1 & -1 \end{bmatrix} \tag{10}$$

$$R_3 = \begin{bmatrix} 1 & 2 & 1 \\ 1 & 0 & -1 \\ 1 & -2 & 1 \end{bmatrix} \tag{11}$$

$$R_4 = \begin{bmatrix} 1 & 3 & 3 & 1 \\ 1 & 1 & -1 & -1 \\ 1 & -1 & -1 & 1 \\ 1 & -3 & 3 & -1 \end{bmatrix} \tag{12}$$

$$R_5 = \begin{bmatrix} 1 & 4 & 6 & 4 & 1 \\ 1 & 2 & 0 & -2 & -1 \\ 1 & 0 & -2 & 0 & 1 \\ 1 & -2 & 0 & 2 & -1 \\ 1 & -4 & 6 & -4 & 1 \end{bmatrix} \tag{13}$$

A recursive relationship between the elements of $R_{k+1}$, and that of $R_k$, being a generalization of Pascal's equations, are given for $k = 2, 3, 4, \cdots, n$, initialized by (10), as

$$\begin{aligned} r_{k+1}^{i,1} &:= 1, & \text{for } i = 1, 2, \cdots, k+1; \\ r_{k+1}^{i,j} &:= r_k^{i,j} + r_k^{i,j-1}, & \text{for } j = 2, 3, \cdots, k+1; \\ r_{k+1}^{k+1,j} &:= r_k^{k,j} - r_k^{k,j-1}, & \text{for } j = 2, 3, \cdots, k+1. \end{aligned} \tag{14}$$

This result is proved in a straightforward manner by induction, and is not spelt out here.

*B. Coefficients via the generalized Pascal matrix*

As already noted, the multinomial (3), for each possible $a_1, a_2, \cdots, a_n$ selection, is invariant of the ordering of the $a_i$, and there are then but $n + 1$ possible multinomials. These can then be organized as,

$$s_* := \begin{bmatrix} sign_*(n) \\ sign_*(n-1) \\ \cdot \\ \cdot \\ sign_*(n-n) \end{bmatrix} = R_{n+1} \begin{bmatrix} \rho_0 \\ \rho_1 \\ \cdot \\ \cdot \\ \rho_n \end{bmatrix} = R_{n+1}\rho. \tag{15}$$

This relationship means that the desired coefficients are the solutions of a linear equation as emphasized in the lemma.

**Lemma III.1** *The multinomial representation of the $sign_*$ function of (3) has coefficients $\rho$ satisfying the linear equations (15), restated as,*

$$R_{n+1}\rho = s_*, \tag{16}$$

*where $R_n$, the generalized Pascal matrix, is defined recursively in (10), and (14).*

*C. Inverse and decomposition of the generalized Pascal matrix*

The nature of the inverse of $R_{n+1}$ now assumes importance. We next develop our second main result, namely that $R_n$ has a factorization in terms of the Pascal matrix $P_n$, and inherits the involutary property to within a scaling. In particular, we claim,

**Lemma III.2** *The generalized Pascal matrix $R_n$, as defined recursively in (10), and (14), has the 'involutary' property*

$$R_n^2 = 2^{n-1}I_n, \quad R_n^{-1} = 2^{1-n}R_n. \tag{17}$$

**Proof** It might be thought that the proof of this result would follow simply by induction arguments. However, in our view, it proves simpler to work with matrices in lower triangular form.

To proceed, it proves convenient to first define $F_n$ as the matrix $P_n$ flipped both left to right and top to bottom. In obvious notation, we write,

$$F_n := \mathrm{flip}(P_n), \quad \text{or} \quad f_n^{i,j} = p_n^{n-i,n-j}. \tag{18}$$

Also, define diagonal matrices, in obvious notation, as

$$D_n := diag\{2^0, 2^1, 2^2, \cdots, 2^{n-1}\}, \quad S_n := diag(P_n). \tag{19}$$

$\square$

To proceed with the lemma proof, a decomposition lemma is now stated and proved,

**Lemma III.3** *The generalized Pascal matrix $R_n$, as defined recursively in (10) and (14), has the decomposition in terms of triangular and diagonal matrices as*

$$R_n = 2^{n-1}S_nF_nD_n^{-1}P_n = P_nD_nF_nS_n. \tag{20}$$

**Proof** This follows by induction, which is relatively straightforward because only upper or lower triangular matrices are involved. Our approach is guided by keeping in mind the connection of the matrix elements with polynomial coefficients. Thus an equivalent result to (20) is to post-multiply $R_n$ by the vector $[s^{n-1}s^{n-2}\ldots s^0]'$ and apply both (8) and (9) so that,

$$
\begin{bmatrix}
(s-1)^0(s+1)^{n-1} \\
(s-1)^1(s+1)^{n-2} \\
\cdot \\
\cdot \\
(s-1)^{n-1}(s+1)^0
\end{bmatrix}
= P_n
\begin{bmatrix}
2^0(s+1)^n \\
2^1(s+1)^{n-1} \\
\cdot \\
\cdot \\
2^{n-1}(s+1)^0
\end{bmatrix},
$$

$$
= F_n
\begin{bmatrix}
(2s)^{n-1}(s+1)^0 \\
(2s)^{n-2}(s+1)^1 \\
\cdot \\
\cdot \\
(2s)^0(s-1)^{n-1}
\end{bmatrix}.
$$

These equations are now in a form that they can be verified by straightforward induction arguments. The pattern of the argument becomes clear in passing from $n = 1$ to $n = 2$, and $n = 2$ to $n = 3$, so that passing from $n$ to $n + 1$ is then straightforward. It is necessary to exploit the Pascal equations which are inherent in the Pascal matrix $P_n$ construction, and suitably adjusted for the 'flipped' version $F_n$. Further details are omitted. $\square$

**Proof** The proof of (17) follows from (20) by substitution and noting in turn that $S_n, P_n, F_n$ are each readily verified as involutary. Thus,

$$
\begin{aligned}
(R_n)(R_n) &= (P_nD_nF_nS_n)(2^{n-1}S_nF_nD_n^{-1}P_n), \\
&= 2^{n-1}P_nD_nF_nF_nD_n^{-1}P_n, \\
&= 2^{n-1}P_nD_nD_n^{-1}P_n, \\
&= 2^{n-1}P_nP_n, \\
&= 2^{n-1}I_n.
\end{aligned}
$$

$\square$

*D. Coefficients from columns of the generalized Pascal matrix*

The above lemmas III.1, III.2 together give our main result stated as a theorem.

**Theorem III.1** *The multinomial representation of the sign* function of (3) has coefficients $\rho$ satisfying the linear equations (15), restated as,

$$\rho = 2^{-n} R_{n+1} s_*. \tag{21}$$

*where $R_n$, the generalized Pascal matrix, is defined recursively in (10), and (14), and satisfies (20) and (17).*

This result means that matrix inverses are avoided in calculating coefficients. This becomes significant for large $n$.

This result for $sign_* - sum$ functions generalizes trivially to any nonlinear function $f(a_1, a_2, \ldots, a_n)$ which is invariant of the ordering of the $a_i$. The $s_*$ vector is then replaced by a vector with $j^{th}$ element $f(-1, -1, \ldots, 1, 1, 1, \ldots, 1)$, where there are $j$ elements of the data set being $-1$, and $n - j$ unity elements.

For completeness, we tabulate the coefficients for low $n$, and point out certain properties which can be established by induction.

|          | n=2 | n=3 | n=4 | n=5 | n=6 | n=7 | n=8 |
|----------|-----|-----|-----|-----|-----|-----|-----|
| $\rho_0$ | 0 | 0 | 0 | 0 | 0 | 0 | 0 |
| $\rho_1$ | $\frac{1}{2}$ | $\frac{1}{2}$ | $\frac{3}{8}$ | $\frac{3}{8}$ | $\frac{5}{16}$ | $\frac{5}{16}$ | $\frac{35}{128}$ |
| $\rho_2$ | 0 | 0 | 0 | 0 | 0 | 0 | 0 |
| $\rho_3$ | 0 | $-\frac{1}{2}$ | $-\frac{1}{8}$ | $-\frac{1}{8}$ | $-\frac{5}{80}$ | $-\frac{5}{80}$ | $-\frac{5}{128}$ |
| $\rho_4$ | 0 | 0 | 0 | 0 | 0 | 0 | 0 |
| $\rho_5$ | 0 | 0 | 0 | $\frac{3}{8}$ | $\frac{5}{80}$ | $\frac{5}{80}$ | $\frac{3}{128}$ |
| $\rho_6$ | 0 | 0 | 0 | 0 | 0 | 0 | 0 |
| $\rho_7$ | 0 | 0 | 0 | 0 | 0 | $-\frac{5}{16}$ | $-\frac{5}{128}$ |

TABLE I

TABLE FOR *sign* FUNCTION MULTINOMIAL COEFFICIENTS.

Specific relationships between the coefficients are clear from the tables and can be proved by induction arguments, as follows. For Table I, for the *sign* operation,

$$
\begin{aligned}
\rho_i^{(n)} &= 0, && \text{for } i = 0, 1, 3, \ldots \text{ and all } n, \\
\rho_i^{(n)} &= \rho_i^{(n-1)}, && \text{for all } i \text{ and } n = 3, 5, 7, \ldots, \\
sign(\rho_i^{(n)}) &= -1, && \text{for all } n \text{ and } i = 3, 7, 11, \ldots, \\
sign(\rho_i^{(n)}) &= 1, && \text{for all } n \text{ and } i = 1, 5, 9 \ldots,
\end{aligned}
\tag{22}
$$

|          | n=2 | n=3 | n=4 | n=5 | n=6 | n=7 | n=8 |
|----------|-----|-----|-----|-----|-----|-----|-----|
| $\rho_0$ | $\frac{1}{2}$ | 0 | $\frac{3}{8}$ | 0 | $\frac{5}{16}$ | 0 | $\frac{35}{128}$ |
| $\rho_1$ | $\frac{1}{2}$ | $\frac{1}{2}$ | $\frac{3}{8}$ | $\frac{3}{8}$ | $\frac{5}{16}$ | $\frac{5}{16}$ | $\frac{35}{128}$ |
| $\rho_2$ | $-\frac{1}{2}$ | 0 | $-\frac{1}{8}$ | 0 | $-\frac{5}{80}$ | 0 | $-\frac{5}{128}$ |
| $\rho_3$ | 0 | $-\frac{1}{2}$ | $-\frac{1}{8}$ | $-\frac{1}{8}$ | $-\frac{5}{80}$ | $-\frac{5}{80}$ | $-\frac{5}{128}$ |
| $\rho_4$ | 0 | 0 | $\frac{3}{8}$ | 0 | $\frac{5}{80}$ | 0 | $\frac{3}{128}$ |
| $\rho_5$ | 0 | 0 | 0 | $\frac{3}{8}$ | $\frac{5}{80}$ | $\frac{5}{80}$ | $\frac{3}{128}$ |
| $\rho_6$ | 0 | 0 | 0 | 0 | $-\frac{5}{16}$ | 0 | $-\frac{5}{128}$ |
| $\rho_7$ | 0 | 0 | 0 | 0 | 0 | $-\frac{5}{16}$ | $-\frac{5}{128}$ |
| $\rho_8$ | 0 | 0 | 0 | 0 | 0 | 0 | $\frac{35}{128}$ |

TABLE II

TABLE FOR *sign*$_\pm$ FUNCTION MULTINOMIAL COEFFICIENTS.

and for Table II, for the $sign_\pm$ operation,

$$
\begin{aligned}
\rho_i^{(n)} &= 0, && \text{for } i = 0, 2, 4, \ldots, \\
& && \text{and } n = 3, 5, 7, \ldots, \\
\rho_i^{(n)} &= \rho_i^{(n-1)}, && \text{for } i = 1, 3, 5, \ldots, \\
& && \text{and } n = i+2, i+4, i+6, \ldots, \\
\rho_i^{(n)} &= \rho_{i-1}^{(n)}, && \text{for } i = 1, 3, 5, \ldots, \\
& && \text{and } n = i+1, i+3, i+5, \ldots, \\
sign(\rho_i^{(n)}) &= +1, && \text{for all } n \text{ and } i = 0, 1, 4, 5, 8, 9 \ldots, \\
sign(\rho_i^{(n)}) &= -1, && \text{for all } n \text{ and } i = 2, 3, 6, 7, 10, 11, \ldots,
\end{aligned}
\tag{23}
$$

There is also symmetry in the coefficients for each odd $n$. Indeed for this case the coefficients for $sign$ and $sign_\pm$ are identical (since then $sign_\pm \equiv sign$).

We see that Table II can be constructed using these various properties and the entries in Table I. Moreover, all coefficients can be constructed from the subset of Table I, namely the $\rho_i^n$ for $i, n$ odd, $i < n/2$.

It is readily seen that for $n > 2$, and either coefficient selection, in obvious notation, then $\sum_{i=1}^{n+1} P_{n+1}(n, i)\rho_{i-1}^{(n)} = -1$, and $\sum_{i=1}^{n+1} P_{n+1}(n-1, i)\rho_{i-1}^{(n)} = 0$. There are other products of the rows of $P_n$ and $\rho$ vectors which are also 0 or 1 not spelt out.

The generalized Pascal Matrix is the key to the coefficients. It is worth pointing out that although this matrix is not orthogonal, induction arguments show that all odd rows are orthogonal to all even rows, so that $P_n R_n'$ has zero $i, j$ entries where $i$ is even and $j$ is odd.

### IV. MAJORITY LOGIC CODING AND DECODING

In this section, we recall known majority logic coding and decoding algorithms, for which we now have complete multinomial representations. These lead to new majority logic coding algorithms and useful code properties in the following two sections.

#### A. Majority logic coding

In communication systems based on majority logic coding and decoding, the multinomial expansion (3) represents the baseband transmitted signal. The $a_i$ of (3) are the product of polar binary message data $d_i$ and known time functions of polar binary sequences. The time functions $X_i(t)|t \in [0, T)$ are defined over a time interval $[0, T)$, derived from codewords.

The data is denoted as a row vector $d := [d_1 \quad d_2 \ldots d_n]$. The codewords $X_i$, are denoted as row vectors of length $\ell$, forming an $n \times \ell$ code matrix $X$ with rows of $X_i$. The time functions representing the encoded data for baseband transmission, are designed to be constant within (equal) time slots called chips. They are defined over a time interval $T$ of $\ell \geq n$ chips. In this case the coded transmitted signals are denoted as $s_*(\cdot)$ in continuous time, or $s_* := [s_1 \quad s_2 \ldots s_\ell]$ in discrete time,

$$
\begin{aligned}
s_*(t) : &= sign_* \left( \sum_{i=1}^{n} d_i X_i(t) \right), \\
s_* : &= sign_*(dX).
\end{aligned}
\tag{24}
$$

Notice that for $n$ even, then application of the $sign$ function leads to ternary transmitted signals, but for $n$ odd they are polar binary, like the $sign_\pm$ for all $n$. The simplicity of the majority logic encoding operation is a key virtue, which also carries over to the decoding operation.

Consider the multinomial expansion for $s$ and for $s_\pm$ in the discrete time case, namely (3) with the $a_i$ replaced by $d_i X_i$. Of course, the coefficients are the same for $n$ odd, see also the Tables I and II. However, in the case $n$ even, and with $X$ orthogonal in that $XX' = I_n$, the coefficient squared of each component represents the energy contribution from each component. For the $sign$ case, $s_i$ can be zero and still carry information, and there is no transmission of the product $d_1 d_2 \cdots d_n$.

### B. Majority logic decoding

At the receiver, the received signal $r(t)$ is the transmitted signal with added noise $w(t)$, as $r(t) = s_*(t) + w(t)$. For decoding to estimate $d_i$, one can work with an optimal *maximum likelihood decoder*, but the complexity grows as $2^n$, since there must be a decorrelation for each of the $2^n$ possible data sets $d := [d_1, d_2, \ldots, d_n]$.

There is incentive then, to consider a much simpler decoding process termed a *majority logic decoding*, as

$$\widehat{d_i} := sign_\pm \left( \int_0^T \frac{(r(t) - \rho_0)}{n\rho_1} X_i(t) dt \right). \tag{25}$$

Here, we use $sign_\pm$, rather than $sign_*$ to ensure that the estimate is bipolar binary.

Experimentally, there are codes, termed *majority logic codes*, which achieve error-free decoding in the noise free case, in that $\widehat{d_i} = d_i$ when $r(t) = s_*(t)$. In the added noise case, for sufficiently small noise, the $sign_*$ operation preserves $\widehat{d_i} = d_i$. How can such codes work? How can such codes be constructed and optimized? How can decoding of such nonlinear codes be simplified?

### C. Error-free decoding in the noise-free case

Different majority logic codes achieve differing robustness to noise, but in order to be considered at all, it is a usual requirement that they have no deterministic errors. That is, denoting a matrix $D$ of all $2^n$ possible bipolar data $D_i$ in its rows, then

$$D = sign_\pm \left( sign_*(DX)X' \right). \tag{26}$$

This equations (26) can be used to search for suitable codes, in that random or other selections of $X$ can be tested for suitability.

A simply proved, but very useful result is the following:

**Lemma IV.1** *Consider a code matrix $X$ which achieves error free majority logic coding and decoding in the noise-free case, in that (26) holds. Then any signed row or column permutation of this matrix preserves this property of no deterministic coding errors. That is, denoting signed permutation matrices of dimension $n$ as $\Pi_n$,*

$$D = sign_\pm \left( sign_*(D[\Pi_n X \Pi_\ell])[\Pi_n X \Pi_\ell]' \right). \tag{27}$$

*Moreover, any one $n \times \ell$ code matrix $X$ can be a basis for generating up to $2^{(\ell+n)} \ell! n!$ code matrices with this property.*

**Proof** Any signed re-ordering of the rows of $X$ is equivalent to a signed re-ordering of the data, for which no deterministic errors are introduced, by assumption. That is, since $[D\Pi_n]$ is a valid data set, and $\Pi_n'\Pi_n = I_n$, then from (26),

$$[D\Pi_n'] = sign_\pm \left( sign_*([D\Pi_n'][\Pi_n X])[\Pi_n X]' \right). \tag{28}$$

Also, signed re-orderings on the columns of $X$ for the coding process are matched in the decoding process, so there is no total effect. That is,

$$D = sign_* \left( sign_\pm(D[X\Pi_\ell])[X\Pi_\ell]' \right). \tag{29}$$

$\square$

### D. Multinomial representation of decoding

To further understand majority logic decoding, here we build on the work of [3]. We consider first the noise-free case when $r(\cdot) = s_*(\cdot)$.

In $\widehat{d_i}$ of (25), let us substitute the multinomial representation (3) for the $sign_*$ function $s_*(t)$ of (24). We consider one term of the multinomial at a time, and indeed break each term down further and consider one summation component at a time. That is, we consider each possible integral of partial products one at a time for $i = 1, 2, \ldots n$ as,

$$\begin{aligned}
\widehat{d_i} = \ & sign_*[d_1 \int_0^T X_1(t) \frac{X_i(t)}{n} dt + d_2 \int_0^T X_2(t) \frac{X_i(t)}{n} dt + \ldots \\
& + \frac{\rho_2}{\rho_1} d_1 d_2 \int_0^T (X_1(t) X_2(t)) \frac{X_i(t)}{n} dt + \ldots \\
& + \ldots \\
& + \frac{\rho_n}{\rho_1} d_1 d_2 \ldots d_n \int_0^T (X_1(t) X_2(t) \ldots X_n) \frac{X_i(t)}{n} dt].
\end{aligned} \tag{30}$$

Let us denote a data vector $d$ augmented with partial products as $d^{pp}$, a corresponding coefficient vector as $\rho^{pp}$ and a codeword function vector $X(\cdot)$ augmented with corresponding element by element partial products as $X^{pp}(\cdot)$, and define these from,

$$
\begin{aligned}
d^{pp} &:= [d_1 \ d_2 \ldots d_n, \ (d_1 d_2) \ldots \\
&\quad (d_{n-1} d_n), \ldots, (d_1 d_2 \ldots, d_n)]'; \\
\rho^{pp} &:= [\frac{\rho_1}{\rho_1} \ \frac{\rho_1}{\rho_1} \ldots \frac{\rho_1}{\rho_1}, \ \frac{\rho_2}{\rho_1} \ \frac{\rho_2}{\rho_1} \ldots \frac{\rho_2}{\rho_1}, \ \ldots, \frac{\rho_n}{\rho_1}]'; \\
X^{pp}(\cdot) &:= [X_1(\cdot)' \ X_2(\cdot)' \ldots X_n(\cdot)', \ (X_1(\cdot).X_2(\cdot))' \ldots \\
&\quad (X_{n-1}(\cdot).X_n(\cdot))', \ldots, (X_1(\cdot).X_2(\cdot).\ldots.X_n(\cdot))']'.
\end{aligned}
$$

(31)

The number of distinct partial products of $j$ data bits, or code words is $^nC_j$, so that the number of identical elements in $\rho^{pp}$, separated by commas in (31), are then given from the binomial coefficients as $^nC_1, ^nC_2, \ldots, ^nC_3$, the sum of which is $\sum_{j=1}^{n} {}^nC_j = 2^n - 1$. Thus $d^{PP}, \rho^{pp}$ are $2^n - 1$ row vectors.

Let us denote the rows of $X^{pp}(\cdot)$ as $X_i^{pp}(\cdot)$. When the codewords are represented as an $n \times \ell$ matrix $X$, then denote an augmentation of this as a $2^n \times \ell$ matrix $X^{pp}$, with rows $X_i^{pp}$. Of course, $X = [\underline{1}_n' \ 0 \ 0 \ldots 0] X^{pp}$, where $\underline{1}$ is a vector of $n$ unity elements.

Now the multinomial expansion (30) can be written for $i = 1, \ 2, \ldots n$ as,

$$
\begin{aligned}
\widehat{d_i} &= sign_* \left[ \int_0^T \frac{X_i^{pp}(t) X^{pp}(t)'}{n} dt \ diag\{\rho^{pp}\} d^{pp} \right], \\
&\sim sign_* \left( \frac{X_i^{pp}(X^{pp})'}{n} \ diag\{\rho^{pp}\} d^{pp} \right).
\end{aligned}
$$

(32)

## V. PARTIAL PRODUCT ESTIMATION FOR ENHANCED DECODING

In this section, we first recall known concepts to reduce majority logic decoding errors in the noise case, using partial product estimation, but then give new results for this based on explicit multinomial expansions, and propose new majority logic coding algorithms to assist this process.

### A. Estimation of data partial products

Partial products $d_i, d_i d_j, d_i d_j d_k, \ldots$, can be estimated via a generalization of (25), for $i = 1, \ 2, \ldots 2^n - 1$ as,

$$
\widehat{d_i^{pp}} := sign_* \left( \int_0^T \frac{(r(t) - \rho_0)}{n \rho_1} (\rho_i^{pp})^\dagger X_i^{pp}(t) dt \right).
$$

(33)

Here $\dagger$ denotes an inverse when $\rho^{pp} \neq 0$, and zero otherwise. Clearly, the partial products with zero coefficients $\rho_i^{pp}$ in the multinomial expansion, and $(\rho^{pp})_i^\dagger = 0$ can not be estimated: Our equations set these products and their estimates to zero.

The partial products of $d_i$, are in fact parity bits, so that the vector $d^{pp}$ can be viewed as message bits together with parity bits. The multinomial expansion of $d^{pp}$ in the noise free case is,

$$
\begin{aligned}
Y(X) &:= \int_0^T diag\{(\rho^{pp})^\dagger\} X^{pp}(t) X^{pp}(t)' diag\{\rho^{pp}\} dt, \\
&\sim diag\{(\rho^{pp})^\dagger\} X^{pp}(X^{pp})' diag\{\rho^{pp}\}, \\
\widehat{d^{pp}} &= sign_* (Y(X) d^{pp}).
\end{aligned}
$$

(34)

Here, $diag\{\rho^{pp}\}$ denotes a diagonal matrix with $i^{th}$ diagonal element $\rho_i^{pp}$.

*B. Error-free parity bit estimation in the noise-free case*

Let us denote the matrix of all possible data vectors $D$ augmented with their partial products as $D^{pp}$. Its rows $D_i^{pp}$ are in the form $(d^{pp})'$ of (31).

We further allow a selection of the data and partial products via an indicator matrix $\mathcal{I}_{(2^n-1)}$, which is unity in selected diagonal elements and zero otherwise, and work with the matrix $D^{pp}\mathcal{I}_{(2^n-1)}$. We set the $i, i$ element of the indicator zero where $\rho_i^{pp} = 0$.

There are no deterministic errors for the estimation of both data and partial products if,

$$D^{pp}\mathcal{I}_{(2^n-1)} = sign_\pm \left( (sign_*(DX) - \rho_0)(X^{pp})'(\rho^{pp})^\dagger \right) \mathcal{I}_{(2^n-1)}. \tag{35}$$

Of course, when $\mathcal{I}_{(2^n-1)} = I_{(2^n-1)}$, then all data and partial products are involved. An indicator matrix pointing to all partial products that can be estimated is $\mathcal{I}_{(2^n-1)} = diag\{sign(|\rho^{pp}|)\}$.

It is clear that the partial product estimates may not be free of errors, even in the noise free case, unless $Y$ is suitably diagonally dominant; more on this in the next section. It is also clear that for the *sign* operation, the multinomial does not contain partial products of an even number of data, so that these can not be estimated with conventional coding. We propose a novel coding to facilitate the estimation of partial products in a later subsection.

## VI. COMBINED LINEAR AND MAJORITY LOGIC CODING

Here we propose a majority logic coding scheme which comprises a first stage of linear coding with its own spreading factor, followed by a second compatible stage of majority logic coding with its own spreading factor, and a single stage majority logic decoding to recover the data. That is, we consider the majority logic coding (24) and decoding (25), but with the data $d_i$ preprocessed in a linear coding stage.

In particular, here the linear preprocessing stage is simply the augmentation of the data with partial products. The result is denoted $d_i^p$, which can spread to the full complement of partial products $d_i^{pp}$. Also, codewords $X_i$ are replaced by codewords augmented with corresponding partial products $X_i^p$, up to the full complement $X_i^{pp}$ as,

$$s_*(t) : = sign_* \left( \sum_{i=1}^n d_i^p X_i^p(t) \right),$$
$$s_* : = sign_*(d^{pp}X^p), \tag{36}$$

$$\widehat{d_i^p} := sign_+ \left( \int_0^T \frac{(r(t) - \rho_0)}{n\rho_1} X_i^p(t)dt \right). \tag{37}$$

These will give error free decoding in a noise free environment if, denoting the matrix of all possible data vectors $D$ augmented with the partial products as $D^p$,

$$D^p = sign_\pm \left( sign_*(D^p X^p)(X^p)' \right). \tag{38}$$

We stress that the nonlinear stage only codes for $T$ codewords, even though its input is $n$ data bits plus parity bits.

In the noisy channel case, of course a maximum likelihood decoding of the data can be simply implemented, but this tends to be prohibitive as the data size and spreading factors increase to practical values. Consequently, a two stage decoding can be applied as follows:

First apply the standard decoding to recover estimates of the data augmented with partial products as $\hat{d}^p$. These can be hard decision estimates using the usual linear operation followed by the $sign_\pm$ operation, or preferably soft decision estimates from just the linear operation without taking the $sign_\pm$ operation.

Then use standard decoding to recover the data estimates from $\hat{d}^p$. One such decoding approach using majority logic operations is as follows: First estimate each data bit $d_i$ from each of the entries in the augmented vector $\hat{d}^p$ which are dependent on $d_i$, using whatever knowledge is available on the other bits. Then add these estimates and take the $sign_+$ operation which is a majority logic operation. There are options for the first operation. For example, if there is a parity bit $d_1 d_2$, then estimating $d_1$ from this, one can use in obvious notion $\frac{d_1 d_2}{\hat{d}_2}$, where $\hat{d}_2$ is the currently available, preferably soft, estimate of $d_2$.

We note an illustrative example of where this combined linear-majority logic coding approach is immediately useful. In the case of majority logic coding for five data spreading to eight chips, there is no code which gives error free decoding in the noise free case. However, by augmenting with one or two parity bits, error free decoding of the data and parity bits can be achieved. Indeed, the addition of one product parity bit in the case of an even number of data bits, and working with a *sign* function, turns out to be equivalent to working with a *sign* function using only the original data. (Details are omitted on this).

In contrast, for the case of three data bits spreading to eight chips, our simulation studies indicate no advantage, or disadvantage, in augmenting with parity bits in a preprocessing linear coding stage, but the computational effort in decoding is greater to work with two stages. However, including the linear preprocessing stage, which is subject to analysis, allows a "more satisfactory" analysis of the overall coding, since the nonlinear coding applies to less spreading.

### A. On correcting data estimation errors using the product parity bit estimate

There is a challenge to achieve virtually optimal decoding of majority logic coding without resorting to *maximum likelihood decoding* in continuous time. An approach proposed in [3], when *estimates of the data and the one product parity bit is available by virtue of the multinomial expansion without changing the coding*, is now recalled. It aims to correct one bit estimation error in a data vector estimate, assuming that there is only one such error.

Prior to taking the sign operation to achieve $d^p$ estimates, select the particular value which has least magnitude, but only in the case that this is a data bit estimate. Assume the $sign_+$ of this value is a bit error, but that all other bit estimates and partial product estimates are correct. Then re-estimate this bit from the remaining $\tilde{d}_j^p$, and the partial product estimate. This approach is claimed to work well in low noise, but our experience illustrated by an example in a later section suggests that if it does, then it is when the noise level is virtually zero and there are virtually no errors anyway. Certainly, in high noise, this approach introduce additional errors into the system.

Our conclusion is that the approach described in the beginning of this section is closer to optimal, but is still not necessarily a good option.

### VII. A DIAGONAL DOMINANCE PROPERTY FOR MAJORITY LOGIC CODES

In this section, we seek to characterize codes for majority logic coding, which are free of deterministic errors. Of course, random or systematic search or numerical test procedures can be used, to ensure that (26), or (38) is satisfied. This is of order $2^{n\ell}$ in its raw form. Here, we develop theory based on the 'diagonal dominance' properties of $Y(X)$ of (34). The multinomial representation of the majority decoding process is expressed in terms of a matrix, which is a simple function of the code matrix $X$, and coefficients $\rho$. First, stronger orthogonality properties are considered.

### A. Codeword orthogonality properties

Many of the insights used in the design of majority logic coding schemes come from thinking in terms of codeword orthogonality. Such conditions can only apply for the case of $n$ even, but they can apply approximately for $n$ odd. We consider first codeword orthogonality, then extended codeword orthogonality and later 'approximate orthogonality'.

*Orthogonality to a constant*: This is essentially a zero mean condition on the codeword matrix $X$,

$$X\underline{1}_\ell = 0. \tag{39}$$

Consider the case when $sign_\pm$ is used with $n$ even, when $\rho_0 \neq 0$. Now if the zero-mean condition (39) holds, then the multinomial expansion for $\tilde{d}_i$ is invariant of $\rho_0$, so we can take $\rho_0 = 0$ as in the case $n$ odd.

This zero-mean property on $X$ excludes generating any code word from any sequence of constant amplitude (i.e. The first row of the Hadamard matrix which is all $+1$).

*Orthogonal codeword property*: Of course, if the codewords are orthogonal to each other, then $XX' = nI_n$. Here we consider orthogonality of particular extended codeword sets, including parity bits of partial products. Such a condition is that $X^{pp}(X^{pp})' = (2^n - 1)I_{(2^n-1)}$. However, for our purposes we define codeword orthogonality in terms of $Y(X) := (Y_{i,j}(X))$, as

$$Y_{i,j}(X) = 0, \quad \text{when } i \neq j. \tag{40}$$

A relaxation of the orthogonality of $Y(X)$, can be expressed in terms of an indicator matrix $\mathcal{I}$, which is unity in selected diagonal elements and zero otherwise, as

$$(\mathcal{I}_{(2^n-1)}Y(X))_{i,j} = 0, \quad \text{when } i \neq j. \tag{41}$$

Of course, an important special case is when $\mathcal{I}_{(2^n-1)} = diag\{\underline{1}'_n \quad 0 \quad 0\ldots 0\}$, which leads to the condition that the code matrix $X$ is orthogonal. If $\mathcal{I} = I$, then (40) is recovered.

### B. 'Ideal' code from Hadamard matrices

An 'ideal' code having $n$ codewords can be envisaged, which would have the set of all $2^n - 1$ possible products $X_i, X_iX_j, X_iX_jX_k, \ldots$ distinct and orthogonal, that is (40) holds and, at least, $\ell = 2^n - 1$ chips for such a code. The Hadamard matrix is an orthogonal matrix, known to have rows which are Walsh functions with partial products of rows also Walsh functions. Indeed, it can be verified that any $2^n \times 2^n$ Hadamard matrix has a subset, or subsets, of $n$ rows such that this orthogonality property holds.

As an example, consider $n = 3, 2^n - 1 = 7$, and now focus on the $8 \times 8$ Hadamard matrix, denoted $H(8)$. Take three code words of length $\ell = 8$, as the rows $2, 5, 8$ of this matrix, to form the code matrix

$$X = \begin{bmatrix} 1 & -1 & 1 & -1 & 1 & -1 & 1 & -1 \\ 1 & 1 & 1 & 1 & -1 & -1 & -1 & -1 \\ 1 & -1 & -1 & 1 & -1 & 1 & 1 & -1 \end{bmatrix}. \tag{42}$$

Then the partial products of pairs of these codewords constitute the rows $4, 6, 7$ of $H(8)$, and the triple product is row 3. Clearly, altogether the rows constitute all but the first row of $H(8)$, and so are orthogonal with $X^{pp}(X^{pp})' = 8I_7$.

Taking another matrix row as an additional codeword, this row and its attendant partial products, then these are not all distinct from the earlier chosen code words and their partial products. Thus, such sets of four, or more, codewords extracted from the $8 \times 8$ Hadamard matrix, can not constitute an 'ideal' code .

In the case of an 'ideal' code, with (40) holding, then all the summands in the multinomial expansion for $\widehat{d_i}$ involving any $d_j|_{j\neq i}$ would be zero, so there would be guaranteed recovery of $d_i$ in the noise free case. (Such recovery is not excluded in with more codewords than in the 'ideal' case.)

Furthermore, for an 'ideal' code, all the partial products $d_i, d_id_j, d_id_jd_k, \ldots$ can be estimated via (33). The orthogonality condition (40) is satisfied, and $|Y(X)|\underline{1}_\ell < diag\{Y(X)\}$. Consequently, in the noise-free case, there are no deterministic errors in the decoding of all partial products. (Such full partial product recovery appears excluded in the case of more codewords than in the 'ideal' case, although recovery of the data and perhaps one partial product can be achieved in some cases.)

In the case when the received signal has additive noise, the parity bit estimates allow an improved estimation of the message bits, and can be exploited to enhance estimation.

Our numerical studies 'verify' a new result,

**Lemma VII.1** *With the majority logic coding and decoding of data with partial products as in (35),(37), based on Hadamard codeword matrices satisfying (40), then there are no deterministic errors.*

Can the orthogonality condition be relaxed?

### C. Diagonal dominance property

A useful approximation to the orthogonality property (41) for our purposes is a specific 'diagonal dominance' of $Y(X)$ of (34) as,

$$\mathcal{I}_{(2^n-1)}|Y(X)|\underline{1}_\ell < \mathcal{I}_{(2^n-1)}diag\{Y(X)\}. \tag{43}$$

Here $|Y(X)|$ denotes a matrix $Y(X)$ with elements replaced by absolute values, and the inequality includes the case $0 < 0$. We summarize 'immediate' conclusions as,

**Lemma VII.2** *Consider a code matrix $X$ and $Y(X)$ given from (34). Then the diagonal dominance condition (43), for some indicator matrix $\mathcal{I}_{(2^n-1)}$, ensures that there are no deterministic errors in estimating $d^p := d^{pp}\mathcal{I}_{(2^n-1)}$ via*

*(34), in that (38) holds. Moreover, the diagonal dominance condition is implied by the stronger orthogonality condition (41).*

The sufficiency of the data-independent 'diagonal dominance' condition (43) is clear. This condition is by no means necessary, since the data and partial products are not independent. However, it is not straight forward to achieve a data independent necessary condition. Checking for deterministic errors for all possible data is perhaps the only option, but this grows exponentially with the data length. The usefulness or otherwise of the sufficiency condition (43) is illustrated for codes related to the Hadamard codes as follows.

### D. 'Near ideal' codewords from Rademacher matrices

A Rademacher matrix is simply the Hadamard matrix with the first row and column deleted, and can be used to generate $n$ majority logic codewords of length $\ell = 2^n - 1$. Consider the code matrix $X$ of (42), but with the first column deleted, denoted $\overline{X}$, and augmented with partial products as $\overline{X}^{pp}$.

Now $\overline{X}^{pp}(\overline{X}^{pp})'$ is not orthogonal, but its construction ensures the property $\overline{X}^{pp}(\overline{X}^{pp})' = (n)I_{(n-1)} - 1_{(n-1)}1'_{(n-1)}$. However, our numerical studies up to $n \leq 8$ show that $Y(\overline{X})$ is diagonally dominant as defined in (43), for $n$ odd, and for $n$ even only for the *sign* operation for $n \neq 4$, where the dominance condition is satisfied with equality for some $i$.

Our numerical studies for $m \leq 8$ show that certainly for some Rademacher matrices, although the diagonal dominance condition fails, there are invariably no deterministic errors in the noise free case, in that (38) holds. This illustrates the fact that the diagonal dominance condition is only a sufficient condition, not a necessary one. Clearly, this example also illustrates that the gap between necessity and sufficiency will reduce if the even numbered coefficients $\rho_i$ are zero, as when $n$ is odd.

Our numerical studies 'verify' a new result,

**Lemma VII.3** *With the majority logic coding and decoding of data with partial products as in (35),(37), based on Rademacher codeword matrices satisfying (43), then there are no deterministic errors.*

### E. 'Near ideal' codewords from PN sequences

*Pseudo*-random noise (PN) sequences of bipolar binary bits of length $2^n - 1$ and satisfying the so-called correlation properties, see [9], can generate codewords.

Consider a sequence of length $2^n - 1$. Now form a matrix, where each row is a cyclically shifted version of the previous row. These have identical diagonal dominance properties as those generated from the Rademacher matrices. Once the matrices are generated, $n$ codewords can be selected from the rows, which form a basis, in that the remaining rows can be formed by partial products of the codewords to form a matrix $X^{pp}$ such that the diagonal elements of $X^{pp}(X^{pp})'$ are $2N - 1$, but the off diagonal elements are either $+1$ or $-1$, which is different from the Rademacher case. Then the row sums of the $Y(X)$ matrix are the same as for the Rademacher codes. Our numerical studies confirm that the diagonal dominance condition is not necessary in cases for $n \leq 8$.

Our numerical studies 'verify' a new result,

**Lemma VII.4** *With the majority logic coding and decoding of data with partial products as in (35),(37), based on pseudo-random codeword matrices satisfying (40), then there are no deterministic errors.*

### F. 'Near ideal' codewords from the Wing code

We mention also particular code sets (matrices) of [10]. We observe here that these can be generated from a Rademacher matrix of dimension $2^n - 1$ with any one column inverted. Consider, for example, such a selection of three codewords. Take for example rows $3, 5, 6$, of a Rademacher $7 \times 7$ matrix, with the last two columns interchanged. This achieves a 'Wing' code, but it together with its extension of partial products does not constitute a 'Wing' matrix, but rather generates a Rademacher matrix with a column interchange. This being the case, a diagonal dominance condition is satisfied for this set of three codewords, so that these will not generate deterministic errors in a majority logic coding.

*G. Low processing gain code words*

The spreading factor of any 'ideal' or 'near ideal' code, such as those based on the Hadamard matrix, Rademacher and PN sequences as above, would be $\frac{2^n}{n}$, or $\frac{2^n-1}{n}$. This is considered too high unless $n$ is a 'small' integer, such as $2, 3, 4$.

With $\frac{\ell}{n} << 2^n$, instead of all code words and their sums of partial products being orthogonal to one another, some pairs of this set will not be orthogonal.

It appears preferable for robust decoding to have the 'diagonal dominance' condition (43) holding, and indeed to maximize in some sense 'diagonally dominance' or the inequalities in (43).

One approach is to seek to maximize the number of pairs of partial codeword products that are orthogonal, or equivalently, to achieve maximum sparcity in $Y(X)$ of (43).

A second approach is to minimize the maximum relevant row sum of $|Y(X)|$.

Special cases are of interest and for some of these we note additional properties of the coefficients $\rho$.

*H. Coefficients $\rho^{pp}$*

Using the formula (15), it is verified that

$$sign(\frac{\rho_n}{\rho_1}) = \left\{ \begin{array}{l} 0 \ \text{for} \ n \ \text{even}, \\ -(1)^{\frac{n}{2}}, \ \text{for} \ n \ \text{odd}. \end{array} \right. \tag{44}$$

Also, $S_{rem} := \sum_{j=2}^{n-1} \frac{|\rho_j|}{|\rho_1|} < 1$ is a monotonically decreasing value as $n$ increases, for either $n$ even or odd, at least for $n > 4$. An induction argument can be developed for these properties. For reference, we list some $S_{rem}$ values,

| $S_{rem}$ | $sign$ | $sign_\pm$ | $S_{rem}$ | $sign$ | $sign_\pm$ |
|---|---|---|---|---|---|
| n=2 | 0 | 0 | n=3 | 0 | 0 |
| n=4 | 0.3333 | 0.6667 | n=5 | 0.3333 | 0.3333 |
| n=6 | 0.4000 | 0.8000 | n=7 | 0.4000 | 0.4000 |
| n=8 | 0.3714 | 0.7429 | n=9 | 0.3714 | 0.3714 |
| n=10 | 0.3175 | 0.6439 | n=11 | 0.3175 | 0.3175 |
| n=12 | 0.2641 | 0.5281 | n=13 | 0.2641 | 0.2641 |
| n=14 | 0.2191 | 0.4382 | n=15 | 0.2191 | 0.2191 |
| n=16 | 0.1835 | 0.3671 | n=17 | 0.1835 | 0.1835 |
| n=18 | 0.1560 | 0.3120 | n=19 | 0.1560 | 0.1560 |

*I. Orthogonal codeword and codeword products case*

Let us consider the case when at least the codeword matrix augmented with the product of all codewords is orthogonal. Then the first $n$ summands in the multinomial expansion (30) simplify as $d_i$, and the last term is zero. What influence do the remaining terms have?

Now consider in addition, that all but one of $^nC_j$ entries in a row $X_i$ with identical coefficient $\rho_j$ is zero. The explicit formula for the coefficients (15), allows us to verify, at least numerically, that in the multinomial expansion for $\widehat{d_i}$ the summation of terms involving the $\rho_j$ coefficients for $j \neq 1, n$, denoted $S_{rem}$ earlier, are in magnitude less than 1, so there is diagonal dominance as in (43) holding, and $\widehat{d_i} = d_i$. That is, under our orthogonality assumptions, the sum of the magnitudes of remaining terms satisfies is $S_{rem} := \sum_{j \neq 1, n}^{n} \frac{|\rho_j|}{|\rho_1|} < 1$.

Consider a useful example of an $8 \times 8$ Hadamard matrix with the first row deleted. Now for codewords defined as certain $n = \{4, 6, 7\}$ row selections of this matrix, respectively, this particular orthogonality property holds, so that there are no deterministic errors for the data estimates in these cases. Moreover, there are no deterministic errors in estimating the product of all codewords using the $sign_\pm$ function, or the $sign$ function for $n = 7$. For the case of $n = 5$ codewords, the orthogonality condition fails, and there is always one data bit that can not be estimated without deterministic errors, and the product of codewords can not be estimated. (The cases of $n = \{1, 2, 3\}$ code words would come under the heading 'ideal' codewords, as earlier.)

Another useful example are 3 codewords constructed from the rows of a $4 \times 4$ Hadamard matrix with the first row deleted. Again, the dominance condition is satisfied and there are no errors in estimating the data or product of the data in the noise-free case.

*J. Other examples of error-free majority logic coding*

Of course, the conditions for error-free majority logic decoding explored above can be relaxed, but the orthogonality assumptions are then more detailed. Also, it becomes more difficult to find codes which satisfy such conditions.

## VIII. Comparative Performance in White Noise

In this section we presented the bit error rate (BER) performance for example majority logic coding schemes detailed in this paper in the presence of additive white Gaussian noise (AWGN) in Figure 1. We consider majority logic coding schemes with $n = 3$ and $\ell = 8$. The legend 'ML Type A' represents the plot for "standard" majority logic coding scheme of Section IV, using the code matrix from (42). Legend 'ML Type B' represents the BER performance plot for the majority logic scheme proposed in Section VI, using an additional 3 linear parity bits based on the code matrix of (42), namely, $row1 \times row2$, $row1 \times row3$ and $row2 \times row3$. The legend 'ML Type C' represents the performance of the majority logic coding scheme introduced in [3], also using the code matrix of (42) and a parity bit estimated from the multinomial representation. For comparison, the BER performance of a maximum likelihood coding scheme is also plotted in Figure 1.

Fig. 1.   BER performance of majority logic coding schemes over the AWGN channel. ((*Note: ML = Majority Logic*)

From Figure 1, when the proposed majority logic coding scheme with partial parity is used, we observe an almost identical coding performance to the conventional scheme. It is our conjecture that in this case, the gain attained via the additional linear partial parity bits are offset by the loss in nonlinear code strength.

We can also observe that assumption made by the scheme of [3] does not always hold thus, the resultant performance is less than that of the traditional majority logic scheme. This loss in performance is due to the fact that under condition of high noise, the probability of error in the parity bit is quite high thus, when used together in the information detection process will result in a higher error rate. On the other hand, under very low noise conditions, the additional parity bit will only add to the strength of the detection process, hence giving a better overall bit error rate performance.

Finally, as sub-optimal coding schemes, majority logic coding schemes with their simpler detection algorithms can deliver a comparable performance to a much more complicated optimal maximum likelihood scheme within a SNR range of 1 to 2 decibels over the AWGN channel.

## IX. Conclusions

Majority logic coding for communication systems has attractive advantages in terms of the simplicity of the decoding. This is achieved at the expense of optimality. The majority logic operations involved are highly nonlinear, so there has been a paucity of theory for developing codes and guaranteeing properties.

A key step in this direction, taken in this paper has been the generation of an explicit formula for the multinomial representation of the various *sign* operations involved in majority logic. The formula is readily calculated in terms of

binomial coefficients, appearing in a proposed generalized Pascal matrix. A factorization of this matrix, in terms of a lower Cholesky factor of the original Pascal matrix, turns out to simplify the proof and derivation of the coefficients. The results are more complete than hitherto given for the case of $sign$, and are new for the $sign_\pm$ case.

The next step has been the proposal of a diagonal dominance condition on functions of any codeword and the multinomial expansion coefficients. This diagonal dominance is proved to be a sufficient condition for guaranteeing error-free coding and decoding in a noise-free environment. It has been shown to be useful in guaranteeing deterministic error-free coding and decoding for known classes of majority logic codes, in particular codes base on Hadamard matrices, Rademacher matrices, and $pseudo$-random sequences. Previously, only numerically verified versions of such results via exhaustive search have been available for low dimensional cases.

Finally, new majority logic coding algorithms have been proposed which are essentially two stages of codings, the first being a linear stage and the second a compatible majority logic stage. The majority logic stage is based on code matrices extended with partial products to be applied to data extended with partial products. The two stage codes and corresponding decoding, appear to work as well as or better than single stage codes, and at least the linear stage is more amenable to analysis.

## REFERENCES

[1] T. Maseng Performance Analysis of a Majority Logic Multiplex System *IEEE Transactions on Communications*, vol. COM-28, no. 9, September 1980.

[2] A. Sugiura and M. Inatsu An amplitude limiting CDM by using majority logic. *IEICE Transactions on Fundamentals of Electronics, Communications and Computer Sciences*, vol. E80-A, no. 2, pp. 346-348, Feb. 1997.

[3] V.P. Ipatov, Y.A. Kolomensky, and R.N. Shabalin Reception of Majority-Multiplexed Signals. *Radio Engineering and Electronic Physics*, vol. 20, no. 4, pp.121-124, 1975.

[4] R.C. Titsworth Application of the Boolean for the Design of a Multi-Channel Telemetric System (in Russian). *Zarubezhnaya Radioelektronika*, 8, 1964.

[5] R.C. Titsworth A Boolean-Function-Multiplexed Telemetry System *IEEE Transactions on Space Electronics and Telemetry*, vol. SET-9, pp42-45, June, 1963.

[6] J.A. Gordon and R. Barrett Correlation-recovered adaptive majority multiplexing *Proceedings of IEE*, vol. 118, no. 3/4, pp.417-422, 1971.

[7] A.K. Mukherjee and D. Mukhopadhyay A method for increasing the number of majority multiplexed channels *Proceedings of IEEE*, vol. 66, no. 9, pp.1096-1097, September, 1978.

[8] K.T. Tan, R. Liyanapathirana and K. N. Ngan Error probabilities for sequency majority multiplexing in frequency-nonselective, slowly fading channel - Part 1 & 2 *Proceedings of IEEE 5th ISSSTA*, pp.411-419, September, 1998.

[9] Golomb, Solomon W. *Shift Register Sequences*. Holden-Day, Inc. San Francisco, 1967.

[10] P.A. Wing Code Division Multiplexing. *Monitor-Proc.IREE*, 1, pp.25-28, 1976.

**Claims**

1. A method of hard decision signal detection using the multinomial representation of a non-linear hard threshold function, comprising:

   applying the non-linear hard threshold function on a received composite signal to produce an output signal having signal elements;
   detecting each signal element within the output based on the multinomial representation of the non-linear hard threshold function used; and
   determining the signal elements received based on the detected elements and parity elements derived from the multinomial representation of the non-linear hard threshold function used.

2. A method of multiplexing a stream of coded signals using a non-linear hard threshold function, comprising:

   coding signal elements based on one of conventional block, convolution or turbo coding;
   multiplexing all the coded signal elements output from the coding based on a non-linear hard threshold function; and
   transmitting the multiplexed composite signal in a channel.

3. The method according to claim 2, further comprising decoding the multiplexed composite signal transmitted in claim 2, where the de-multiplexing process is replaced by a soft information decoder operating in a serially concatenated manner with a later stage decoder based on the conventional block, convolution or Turbo decoding scheme.

4. The method according to claim 3, further comprising:

decoding the multiplexed composite signal based on a multinomial representation of the non-linear hard threshold function used and apriori information from the later stage decoder; and

passing out soft decoded information to the later stage conventional block, convolution or Turbo decoder.

**5.** The method according to claim 4, wherein:

The later stage decoder passes out soft decoded and apriori information back to the decoder, in an iterative manner, until the number of required iterations between the two decoder and the later stage decoder has been completed; and

passing the final decoded information is passed on to the next stage.

**6.** A method of implementing a squashing/activation function within an artificial neural network based on a non-linear hard threshold function, comprising:

using a complete multinomial representation of a non-linear hard threshold function as a squashing function within an artificial neural network.

**7.** A method of coding using combined linear and non-linear coding functions, comprising:

deriving parity bits for an uncoded signal;

coding the parity bits based on a linear coding function;

coding the uncoded signal and linear parity bits based on a non-linear hard threshold function; and

transmitting a combined signal based on the coding steps for subsequent linear decoding and non-linear decoding based on a majority logic decoding function.

**8.** A method of decoding a signal using combined linear and non-linear decoding functions, comprising:

receiving a transmitted signal;

decoding for the parity and uncoded signal bits within the received signal based on a multinomial representation of a non-linear hard threshold function;

further decoding for the uncoded signal bits based on a linear coding function; and

determining the received uncoded signal bits based on information from both the nonlinear and linear decoding processes.

**9.** A method of optimizing the decoding of a signal, comprising:

decomposing a non-linear function of the sum of binary data into a complete multinomial representation;

determining the coefficients of the multinomial representation;

implementing the multinomial representation, including the coefficients, in majority logic; and

decoding a signal having properties associated with the non-linear function using the majority logic.

**10.** The method according to claim 9, wherein the non-linear function is a $\text{sign}_*$ function.

**11.** The method according to claim 10, wherein the $\text{sign}_*$ function is a sign function.

**12.** The method according to claim 10, wherein the $\text{sign}_*$ function is a $\text{sign}\_$ function.

**13.** The method according to claim 10, wherein the $\text{sign}_*$ function is a $\text{sign}_+$ function.

**14.** The method according to claim 1, wherein the non-linear function is a sigmoidal function.

**15.** The method according to claim 1, wherein the non-linear function is a sgn function.

**16.** The method according to claim 10, wherein the multinomial representation is given by equation 3.

**17.** The method according to claim 16, wherein the coefficients are determined according to equation 8.

**18.** The method according to claim 16, wherein the coefficients are determined according to equation 21.

**19.** The method according to claim 16, wherein the coefficients are determined according to equation 22.

**20.** The method according to claim 16, wherein the coefficients are determined according to equation 23.

**21.** The method according to claim 9, wherein the signal is coded based on the non-linear function.

**22.** The method according to claim 21, wherein the coded signal is transmitted within a communications system and decoded at the receiving end of the communication system.

**23.** A method of coding using combined linear and non-linear coding functions, comprising:

deriving parity bits for a signal;
coding the parity bits based on a linear coding function;
coding the signal and linear parity bits based on a majority logic coding function; and
transmitting a combined signal based on the coding steps for linear decoding and non-linear decoding based on a majority logic decoding function.

**24.** A method of decoding a signal using combined linear and non-linear decoding functions, comprising:

receiving a signal;
decoding parity bits within the signal based on a majority logic decoding function; and
decoding the signal bits based on a linear coding function.

Begin

Use hard thershold detection
process across entire received
composite signa, instead of for
each individual signal element

Detect for individual signal
element within the hard
threshold decision output

Detect for additional signal
elements within the hard
thershold decision based
on the complete multinomial
representation of the hard
threshold function

Combine all detected signal
elements to arrive at a better
signal than previously possible

End

Figure 1

EP 1 489 749 A2

Figure 2

Figure 3

Figure 4

EP 1 489 749 A2

Figure 5

Figure 6

```
                    ┌─────────────────┐
                    │      Begin      │
                    └─────────────────┘
                             │
                             ▼
┌──────────────────────────────────────────────────┐
│  Use hard threshold decision function             │
│  as artificial neural network squashing/          │
│  activation function                              │
└──────────────────────────────────────────────────┘
                             │
                             ▼
┌──────────────────────────────────────────────────┐
│  Learning algorithms in artificial neural         │
│  network need to differentiate the                │
│  suqashing/activation function in their           │
│  learning process                                 │
└──────────────────────────────────────────────────┘
                             │
                             ▼
┌──────────────────────────────────────────────────┐
│  Squashing/activation function based on           │
│  hard threshold decision is differentiable        │
│  in their multinomial form                        │
└──────────────────────────────────────────────────┘
                             │
                             ▼
                    ┌─────────────────┐
                    │      End        │
                    └─────────────────┘
```

Figure 7

Begin

At the transmitter, first code the
signal elements using linear
coding scheme

Further code the linear parity
elements and signal elem
entsusing non-linear hard
threshold function

At receiver, first deocde received
composite signal using the
multinomial representation
of the non-linear hard threshold
function

Further decode based on the
linear coding scheme used
in the transmitter.Decide on
signal elements received based
on all decoded signals

End

Figure 8

Figure 9

```
                    ┌─────────────────────┐
                    │        Begin        │
                    └─────────────────────┘
                               │
                               ▼
        ┌──────────────────────────────────┐
        │   Determine exact type of        │ ─── 100
        │   non-linear function.           │
        └──────────────────────────────────┘
                               │
                               ▼
        ┌──────────────────────────────────┐
        │   Start deriving for coefficients│ ─── 101
        │   ρ using (15) and Lemma III.1.  │
        └──────────────────────────────────┘
                               │
                               ▼
        ┌──────────────────────────────────┐
        │   Simplify the solving linear    │ ─── 102
        │   equation (16) via Lemma III.2  │
        │   and III.3.                     │
        └──────────────────────────────────┘
                               │
                               ▼
        ┌──────────────────────────────────┐
        │   Derive for coefficients        │ ─── 103
        │   ρ using equation (21).         │
        └──────────────────────────────────┘
                               │
                               ▼
                    ┌─────────────────────┐
                    │         End         │
                    └─────────────────────┘
```